# EUROPEAN PATENT APPLICATION

(11) **EP 1 762 896 A2**
(43) Date of publication of application: **14.03.2007**
(21) Application number: 06016332.6
(22) Date of filing: 04.08.2006
(51) Int. Cl.: G03F 7/16, G03F 7/031, G03F 7/029, G03F 7/033, G03F 7/035

(54) **Method of producing photosensitive planographic printing plate**

(30) Priority: 09.09.2005 JP 2005262663
(71) Applicant: FUJIFILM Corporation, Minato-ku Tokyo (JP)
(72) Inventor: Kuwabara, Katsushi, Yoshida-cho Haibara-gun Shizuoka-ken (JP)
(74) Representative: HOFFMANN EITLE

(57) **Abstract**

A photosensitive planographic printing plate superior in sensitivity, developing efficiency, and printing durability is provided by a method of producing a photosensitive planographic printing plate, which comprises forming a photosensitive layer by applying a coating a solution containing a compound having an addition-polymerizable ethylenic double bond, a polymerization initiator, and a polymerization inhibitor on a substrate, wherein the coating solution is stored at a temperature of 23 to 28°C for 15 to 180 hours after preparation thereof and before application.

## Description

### Background of the Invention

### Field of the Invention

The present invention relates to a method of producing a photosensitive planographic printing plate, and in particular, to a method of producing a photosensitive planographic printing plate higher in sensitivity and superior in developing efficiency and printing durability.

### Description of the Related Art

High-sensitivity photo-polymerizable planographic printing plates compatible with Ar⁺ lasers, YAG-SHG lasers, violet laser diodes and the like, and polymerizable planographic printing plates compatible with infrared lasers have been known.

These planographic printing plates normally have a polymerizable photosensitive layer on a substrate.

These planographic printing plates are produced, by preparing a photosensitive composition at least containing a compound having an addition-polymerizable ethylenic double bond and a polymerization initiator in an organic solvent and applying it onto a substrate as the coating solution. Such a composition usually additionally contains a polymerization inhibitor, for suppressing undesirable polymerization reaction in the photosensitive composition (see, for example, Japanese Patent Application Laid-Open (JP-A) Nos. 11-352691 and 10-237118).

In a coating solution of such a photosensitive composition, a polymerization reaction can occur among the components or be inhibited excessively by a polymerization inhibitor, depending on the conditions, during preparation and application, causing variation in the quality of the resulting planographic printing plate. This, in turn, leads to fluctuation in the sensitivity and developing efficiency of the planographic printing plates obtained and further in durability thereof during printing, consequently causing bad development such as undissolved film and residual color during continuous processing of the planographic printing plate and low durability during printing.

### Summary of the Invention

The present invention has been made in view of the above circumstances and provides a method of producing a photosensitive planographic printing plate.

According to an aspect of the invention, provided is a method of producing a photosensitive planographic printing plate, comprising, forming a photosensitive layer by applying a coating solution containing a compound having an addition-polymerizable ethylenic double bond, a polymerization initiator, and a polymerization inhibitor on a substrate, wherein the coating solution is stored at a temperature of 23 to 28°C for 15 to 180 hours after preparation thereof before application.

### Brief Description of the Drawings

Figure 1 is a graph showing the relationship between the film physical properties of the photosensitive layer obtained in the invention and the storage temperature and period of the coating solution.
Figure 2 is a schematic diagram showing an example of the steps from preparation of coating solution to application thereof in the invention.

### Detailed Description of the Invention

After intensive studies, the inventors have found that it was possible to achieve the object by controlling the environment during the period of preparation to application of the coating solution of the photosensitive composition, and completed the present invention.

The methods of producing a photosensitive planographic printing plate according to the invention include the followings:
<1> a method of producing a photosensitive planographic printing plate, comprising, forming a photosensitive layer by applying a coating solution containing a compound having an addition-polymerizable ethylenic double bond, a polymerization initiator, and a polymerization inhibitor on a substrate, wherein the coating solution is stored at a temperature of 23 to 28°C for 15 to 180 hours after preparation thereof and before application,
<2> the method of producing a photosensitive planographic printing plate described in <1>, wherein the storage period is 18 to 168 hours,
<3> the method of producing a photosensitive planographic printing plate described in <1>, wherein the compound having an addition-polymerizable ethylenic double bond is a compound having two or more terminal ethylenic unsaturated bonds,
<4> the method of producing a photosensitive planographic printing plate described in <1>, wherein the polymerization inhibitor is a compound selected from hexaarylbiimidazole compounds, carbon-halogen bond-containing compounds, onium salts, and metallocene compounds,
<5> the method of producing a photosensitive planographic printing plate described in <1>, wherein the coating solution further contains a binder polymer,
<6> the method of producing a photosensitive planographic printing plate described in <5>, wherein the binder polymer is an organic polymer compound soluble in, or swells in, aqueous alkaline solutions,
<7> the method of producing a photosensitive planographic printing plate described in <5>, wherein the binder polymer is an organic polymer compound soluble in water,
<8> the method of producing a photosensitive planographic printing plate described in <5>, wherein the binder polymer is a polyurethane resin having a crosslinking group on a side chain,
<9> the method of producing a photosensitive planographic printing plate described in <1>, wherein the coating solution further contains a sensitization colorant, and
<10> the method of producing a photosensitive planographic printing plate described in <9>, wherein the sensitization colorant is a compound selected from the compounds represented by the following Formulae (I), (II), (III), (IV), and (V): 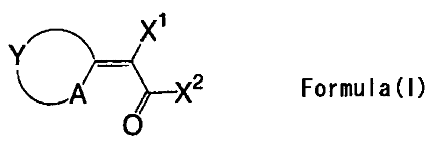
wherein in Formula (I) : A represents a S atom or NR⁶; R⁶ represents a monovalent non-metal atom group; Y represents a non-metal atom group forming a basic ring of a dye, together with the neighboring A and the neighboring carbon atoms; X¹ and X² each independently represent a monovalent non-metal atom group; and X¹, X² may bond together to form an acidic ring of the dye; 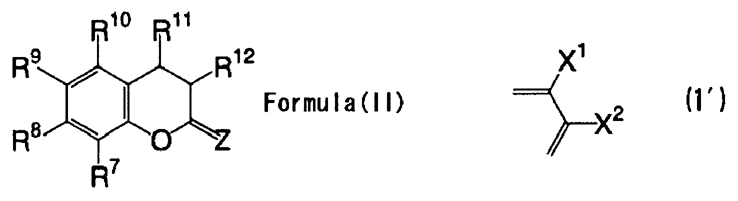 wherein in Formula (II) : =Z represents a carbonyl group, a thiocarbonyl group, an imino group, or an alkylidene group represented by partial structural Formula (1') above; X¹ and X² are the same as those in Formula (I); and R⁷ to R¹² each independently represent a monovalent non-metal atom group; 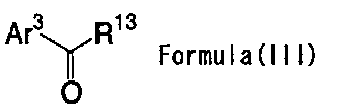 wherein in Formula (III) above, Ar³ represents a substituted or unsubstituted aromatic or hetero aromatic group; and R¹³ represents a monovalent non-metal atom group; more preferable, R¹³ represents an aromatic or heteroaromatic group and Ar³ and R¹³ may bind to each other, forming a ring; 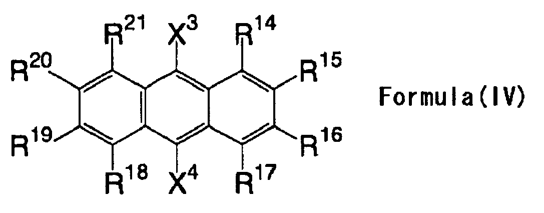 wherein in Formula (IV) : X³, X⁴, and R¹⁴ to R²¹ each independently represent a monovalent non-metal atom group; and more preferably, each of X³ and X⁴ has an electron-donating group having a negative Hammett substituent constant; and 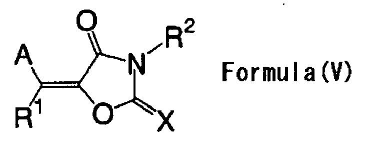 wherein in Formula (V) : A represents a substituted or unsubstituted aromatic or hetero ring; and X represents an oxygen or sulfur atom or N-(R³); R¹, R² and R³ each independently represent a hydrogen atom or a monovalent non-metal atom group; and A and R¹, or R² and R³, may bind to each other, forming an aliphatic or aromatic ring.

The operation mechanism of the invention is still not clear, but seems to be as follows:

It is possible, in the invention, to make the polymerization inhibitor function more efficiently in the coating solution and prevent undesirable polymerization reaction, by controlling the environment of the solution containing a compound having an addition-polymerizable ethylenic double bond, a polymerization initiator, and a polymerization inhibitor in the range above during the period from preparation to application.

Thus, the invention provides a method of producing a planographic printing plate having a polymerizable photosensitive layer on a substrate that is superior in the uniformity of sensitivity, developing efficiency, and printing durability.

The method of producing a photosensitive planographic printing plate according to the invention will be described below.

The invention is a method of producing a photosensitive planographic printing plate by forming a photosensitive layer by applying a coating solution containing a compound having an addition-polymerizable ethylenic double bond (hereinafter, referred to as addition-polymerizable compound), a polymerization initiator and a polymerization inhibitor on a substrate, wherein the coating solution is kept at a temperature of 23 to 28°C for 15 to 180 hours during the period from preparation to application.

Thus in the invention, a coating solution containing the essential components and any other components as needed is characteristically stored in a temperature range of 23 to 28°C for 15 to 180 hours during the period from preparation to application thereof on a substrate.

By storing the coating solution under such a condition, it is possible to make the polymerization inhibitor function more efficiently to suppress polymerization reaction of the photosensitive components in the coating solution and stabilize the state of the coating solution. When a planographic printing plate is obtained by forming a photosensitive layer by using the coating solution thus stored, the planographic printing plate has more uniform sensitivity, developing efficiency, and printing durability. It is thus possible to obtain a planographic printing plate superior in uniformity. As a result, it is possible to prevent the troubles of insufficient development when the planographic printing plates obtained are engraved continuously and the troubles due to poor printing durability when they are used for printing.

In the invention, the period "from preparation to application" means a period from when an addition-polymerizable ethylenic double bond, a polymerization initiator, and a polymerization inhibitor, as well as any other components are added to an organic solvent and the mixture is stirred to when the mixture is applied on a substrate.

When the temperature of the coating solution is lower than 23°C in the invention, the planographic printing plate becomes higher in sensitivity and lower in developing efficiency and an aging period significantly longer than 15 hours is needed for continuous engraving at a desirable sensitivity, and an extended aging period results in deterioration in productivity.

Alternatively, a temperature of higher than 28°C leads to deterioration in the sensitivity and the printing durability of the planographic printing plate within 180 hours and completion of application within a period significantly shorter than 180 hours is needed for continuous engraving at a desirable sensitivity, and a shorter coating period results in deterioration in productivity.

Further in the invention, when the coating-solution storage period is shorter than 15 hours, the planographic printing plate becomes higher in sensitivity, resulting in deterioration in developing efficiency.

On the other hand, a coating-solution storage period of longer than 180 hours leads to deterioration in the sensitivity and thus, the printing durability of the planographic printing plate.

In the invention, the coating solution is preferably kept at a temperature of 23 to 28°C for 15 to 180 hours during the period from preparation and application.

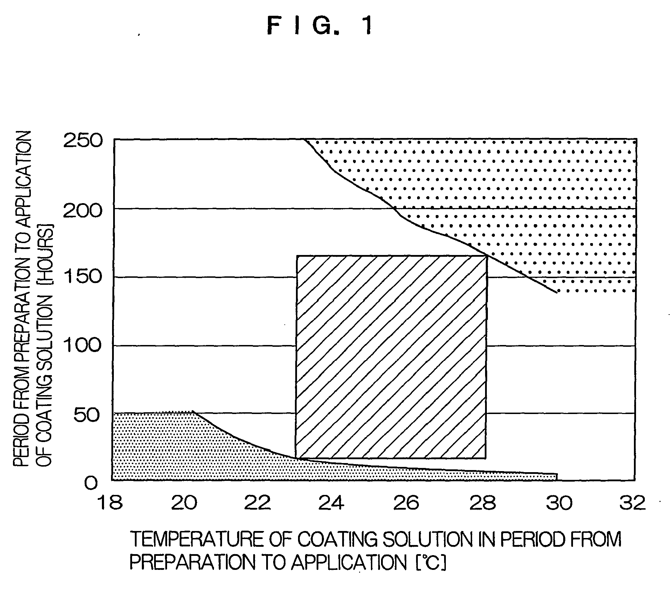

In addition, considering the relationship shown in Figure 1 between the storage temperature and period of the coating solution and the film physical properties of the photosensitive layer obtained, the condition described below is most preferable. Figure

1 above is a graph showing the relationship between the storage temperature and period of the coating solution and the film physical properties of the photosensitive layer obtained in the invention.

The photosensitive layer formed with a coating solution corresponding to the region indicated by coarse dots in the top right of the graph of Figure 1, i.e., a coating solution stored at higher storage temperature for a longer storage period, is often lower in sensitivity and printing durability. On the other hand, the photosensitive layer formed with the coating solution corresponding to the region indicated by fine dots in the left bottom of the graph of Figure 1, i.e., a coating solution stored at lower storage temperature for a shorter storage period, is higher in sensitive but often generates undissolved films during development.

Thus in the invention, the coating solution is most preferably stored in the condition corresponding to the hatched region in the graph of Figure 1, i.e., in a temperature range of 23 to 28°C for 15 to 180 hours, particularly preferably for 18 to 168 hours.

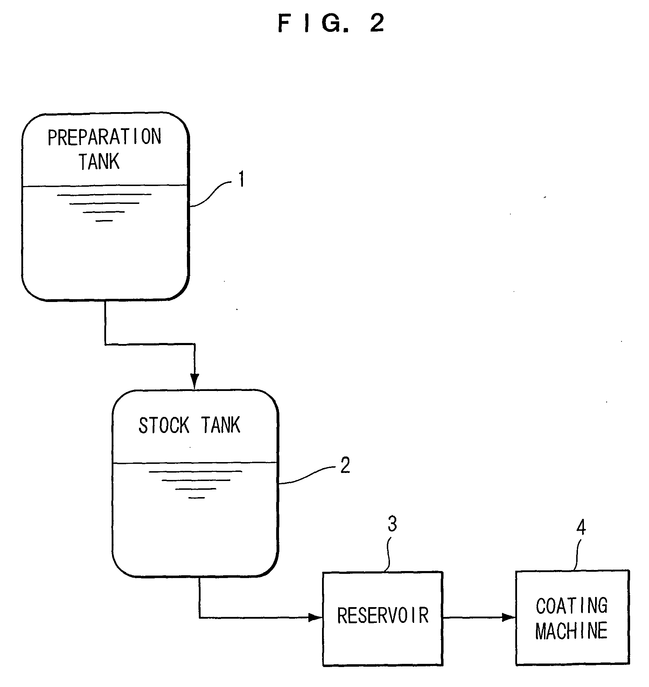

Hereinafter, the method of producing a planographic printing plate according to the invention will be described in detail with reference to Figure 2. Figure 2 above is a schematic diagram showing an example of the steps of preparing a coating solution to application thereof in the invention.

As shown in Figure 2, the coating solution is prepared first by dissolving essential components, an addition-polymerizable compound, a polymerization initiator and a polymerization inhibitor, and any other components used as needed in an organic solvent in a coating solution-preparing tank 1. Although not shown in the Figure, the coating solution-preparing tank 1 is connected to various raw material tanks, and raw materials respectively in desired quantities are supplied to the coating solution-preparing tank 1. The coating solution-preparing tank 1 is connected via a pipe to a stock tank 2, and the coating solution moves in the direction indicated by the arrow.

A temperature control means such as heater or cooler is connected to the coating solution-preparing tank 1, for keeping the temperature of the coating solution in the range above.

The coating solution prepared in the coating solution-preparing tank 1 is fed into the stock tank 2 for storage. The coating solution according to the invention is stored for the longest period in the stock tank 2. The coating solution of the photosensitive composition is stabilized by the storage in that state. The stock tank 2 is connected via a pipe to a reservoir 3, and the coating solution is fed in the direction indicated by the arrow.

A temperature control means is also connected to the stock tank 2, similarly to the coating solution-preparing tank 1, and the temperature of the coating solution is controlled in the range above.

The coating solution stored in the stock tank 2 for a desirable period after stored once in the reservoir 3 is fed to a coating machine 4 communicating therewith via a pipe, and coated on a supporting plate therein.

The temperature control means described above may be installed also in the reservoir 3 and the coating machine 4, or alternatively, the temperature of the coating solution may be controlled by adjusting the internal temperature environment of the room installing the reservoir 3 and the coating machine 4 without installing the temperature control means, because the period of the coating solution in the reservoir 3 or coating machine 4 is shorter.

In the invention, the coating solution prepared in the coating solution-preparing tank 1 should be kept in a temperature range of 23 to 28°C before it is coated by the coating machine 4.

The temperature control means are preferably installed in the coating solution-preparing tank 1 and stock tank 2 as described above for control of the temperature condition, but the temperature of the coating solution may be controlled for example, by adjusting the internal temperature environments of the room in the steps of preparation and application of the coating solution, separately from the method above or in combination. In addition, the temperature of the coating solution may be controlled, by installing temperature control means in the pipe connecting coating solution-preparing tank 1 to stock tank 2, the pipe connecting stock tank 2 to reservoir 3, and the pipe connecting reservoir 3 to coating machine 4.

Also in the invention, the period from preparation to application of the coating solution should be in the range of 15 to 180 hours.

For control of the period, the amount of desirable photosensitive composition and the amount of the composition possibly prepared in the coating solution-preparing tank 1 are calculated from the desirable production quantity; and the amount of the photosensitive composition prepared batchwise and the number of the compositions prepared is calculated from the amount of photosensitive composition consumed during production.

Hereinafter, the coating solution for use in the invention will be described.

The coating solution for use in the invention contains an addition-polymerizable compound, a polymerization initiator, and a polymerization inhibitor as its essential components. Hereinafter, these essential components and other components added as needed will be described in detail..

### (Addition-polymerizable compound)

The addition-polymerizable compound according to the invention is an addition-polymerizable compound having at least one ethylenic unsaturated double bond, and selected from compounds having at least one, preferably two or more, terminal ethylenic unsaturated bond. These compounds are known in the art, and any one of them may be used without restriction in the invention. These compounds are present in various chemical structures, for example in the form of monomer, prepolymer (such as dimer, trimer or oligomer, or the mixture thereof) and the copolymer thereof. Examples of the monomers and the copolymers thereof include unsaturated carboxylic acids (such as acrylic acid, methacrylic acid, itaconic acid, crotonic acid, isocrotonic acid, and maleic acid) and the esters and amides thereof; and, favorable examples thereof include esters of an unsaturated carboxylic acid and an aliphatic polyvalent alcohol compound and amides of an unsaturated carboxylic acid and aliphatic polyvalent amine compound. In addition, addition reaction products of an unsaturated carboxylic ester or an amide having a nucleophilic substituent such as hydroxyl, amino, or mercapto group with a monofunctional or multifunctional isocyanate or epoxy compound, and dehydration condensation products thereof with a monofunctional or polyfunctional carboxylic acid, and the like are also used favorably. Addition reaction products of an unsaturated carboxylic ester or an amide having an electrophilic substituent such as isocyanate or epoxy group with a monofunctional or polyfunctional alcohol, amine, or thiol, and substitution reaction products of an unsaturated carboxylic ester or an amide having an eliminating substituent such as a halogen group or a tosyloxy group with a monofunctional or polyfunctional alcohol, amine, or thiol are also favorable. Other favorable examples include the compounds where the unsaturated carboxylic acid is replaced with an unsaturated phosphonic acid, styrene, vinyl ether, or the like.

Typical examples of the esters of an aliphatic polyvalent alcohol compound and an unsaturated carboxylic acid include acrylic esters such as ethylene glycol diacrylate, triethylene glycol diacrylate, 1,3-butanediol diacrylate, tetramethylene glycol diacrylate, propylene glycol diacrylate, neopentylglycol diacrylate, trimethylolpropane triacrylate, trimethylolpropane tri(acryloyloxypropyl)ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl)isocyanurate, isocyanuric acid ethyleneoxide (EO)-modified triacrylates, polyester acrylate oligomers, and the like; methacrylic esters such as tetramethylene glycol dimethacrylate, triethylene glycol dimethacrylate, neopentylglycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy) phenyl]dimethylmethane, bis-[p-(methacryloxyethoxy)phenyl]dimethyl methane, and the like; itaconate esters such as ethylene glycol diitaconate, propylene glycol diitaconate, 1,3-butanediol diitaconate, 1,4-butanediol diitaconate, tetramethylene glycol diitaconate, pentaerythritol diitaconate, sorbitol tetraitaconate, and the like; crotonate esters such as ethylene glycol dicrotonate, tetramethylene glycol dicrotonate, pentaerythritol dicrotonate, sorbitol tetradicrotonate, and the like; isocrotonate esters such as ethylene glycol diisocrotonate, pentaerythritol diisocrotonate, sorbitol tetraisocrotonate, and the like; and maleate esters such as ethylene glycol dimaleate, triethylene glycol dimaleate, pentaerythritol dimaleate, sorbitol tetramaleate, and the like.

Examples of other favorable esters include the aliphatic alcohol esters described in Japanese Patent Application Publication (JP-B) No.51-47334 and JP-A No. 57-196231; the eaters having an aromatic skeleton described in JP-ANos. 59-5240, 59-5241, and 2-226149; the esters containing an amino group described in JP-ANo. 1-165613; and the like. The ester monomers described above may be used also as a mixture.

Typical examples of the amide monomers of an aliphatic polyvalent amine compound and an unsaturated carboxylic acid include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide, xylylene bismethacrylamide, and the like. Other favorable examples of the amide monomers include the amides having a cyclohexylene structure described in JP-B No. 54-21726.

Urethane-based addition-polymerizable compounds prepared by using addition reaction of an isocyanate and a hydroxyl group are also favorable, and typical examples thereof include the vinyl urethane compounds having two or more polymerizable vinyl group in a molecule described in JP-B No. 48-41708, which were prepared by adding a vinyl monomer having a hydroxyl group represented by the following Formula (a) to a polyisocyanate compound having two or more isocyanate group in a molecule, and the like.

CH₂ =C(R)COOCH₂CH(R')OH Formula (a)

(wherein, each of R and R' represents H or CH₃).

Also favorable are the urethane acrylates described in JP-ANo. 51-37193 and JP-B Nos. 2-32293 and 2-16765; and the urethane compounds having an ethylene oxide skeleton described in JP-B Nos. 58-49860, 56-17654, 62-39417, and 62-39418. It is also possible to obtain an photopolymerizable composition very superior in sensitization speed by using the addition-polymerizable compound having an amino or sulfide structure in the molecule described in JP-ANos. 63-277653, 63-260909, or 1-105238.

Other favorable examples thereof include polyfunctional acrylates and methacrylates such as the polyester acrylates and epoxyacrylates obtained in reaction of an epoxy resin with (meth)acrylic acid described in JP-A No. 48-64183, and JP-B Nos. 49-43191 and 52-30490. Yet other examples thereof include the particular unsaturated compounds described in JP-B Nos. 46-43946, 1-40337, and 1-40336, the vinylphosphonic acid compounds described in JP-A No. 2-25493, and the like. In addition, the structures containing a perfluoroalkyl group described in JP-A No. 61-22048 are used favorably in some cases. Further, the photo-curing monomers and oligomers described in J. Adhesion Soc. Jpn. Vol. 20, No. 7, p. 300 to 308 (1984) are also used favorably.

Details of the use condition, such as structure, single or combined use and addition amount, of the addition-polymerizable compound are determined arbitrarily according to the desirable final properties of the planographic printing plate precursor. They are selected, for example, from the following viewpoints.

From the point of sensitivity, a structure having a higher unsaturated group content per molecule is preferable, and a bifunctional or higher structure is preferable in many cases. A trifunctional or higher structure is preferable, for increase in the strength of the image region, i.e., of the hardened film; and combined use of structures different in functionality and polymerizable group (such as acrylic esters, methacrylic esters, styrene compounds, and vinylether compounds) is effective in controlling sensitivity and strength at the same time.

Selection and usage of the polymerizable compound are also important factors, for the compatibility and dispersibility of other components (e.g., binder polymer, polymerization initiator, colorant, etc.) in the photosensitive layer, and, for example, use of a low-purity compound or combined use of two or more compounds is occasionally effective for improving compatibility. In addition, a particular structure may be selected for improvement in adhesiveness, for example, to the supporting plate and the protective layer described below.

From these viewpoints, the blending rate of the addition-polymerizable compounds in the coating solution is 20 to 80 mass %, preferably 25 to 75 mass %, with respect to the total solid matters in the coating solution in many cases.

These addition-polymerizable compounds may be used alone or in combination of two or more.

### (Polymerization initiator)

Any one of known polymerization initiators may be used as the polymerization initiator according to the invention, and typical examples thereof include (a) aromatic ketones, (b) onium salt compounds, (c) organic peroxides, (d) thio compounds, (e) hexaarylbiimidazole compounds, (f) ketoxime ester compounds, (g) borate compounds, (h) azinium compounds, (i) active ester compounds, (j) carbon-halogen bond-containing compounds, (k) metallocene compounds, and the like.

Among them, (e) hexaarylbiimidazole compounds, (j) carbon-halogen bond-containing compounds, (b) onium salts, and (k) metallocene compounds are preferably, and (e) hexaarylbiimidazole compounds are particularly preferable.

Examples of the hexaarylbiimidazole compounds (e) include the Rofin dimers described in JP-B Nos. 45-37377 and 44-86516, such as 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o, p-dichlorophenyl)-4,4',5,5'-tetraphenylbiimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole, 2,2'-bis(o-trifluorophenyl)-4,4',5,5'-tetraphenylbiimidazole, and the like.

The compound having a carbon-halogen bond (j) is preferably a trihalomethyl compound.

The trihalomethyl compound is preferably a trihalomethyl-s-triazine, and favorable examples thereof include the trihalogen-substituted methyl group-containing s-triazine derivatives described in JP-A No. 58-29803 such as 2,4,6-tris(trichloromethyl)-s-triazine, 2-methoxy-4,6-bis(trichloromethyl)-s-triazine, 2-amino-4,6-bis(trichloromethyl)-s-triazine, and 2-(p-methoxystyryl)-4,6-bis(trichloromethyl)-s-triazine, and the like.

The onium salt (b) is, for example, an onium salt represented by the following Formula (i).

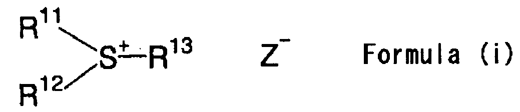

In Formula (i), R¹¹, R¹², and R¹³ each independently represent a hydrocarbon group having 20 or fewer carbon atoms that may have one or more substituents. Favorable examples of the substituent groups include halogen atoms, a nitro group, alkyl groups having 12 or fewer carbon atoms, alkoxy groups having 12 or fewer carbon atoms, and aryloxy group having 12 or fewer carbon atoms. Z⁻ represents a counter ion selected from the group consisting of halide, perchlorate, tetrafluoroborate, hexafluorophosphate, carboxylate, and sulfonate ions, preferably, a perchlorate, hexafluorophosphate, carboxylate, or arylsulfonate ion.

The metallocene compound (k) is, for example, a titanocene compound. The titanocene compound is selected, for example, from the known compounds described in JP-ANos. 59-152396 and 61-151197.

Typical examples thereof include di-cyclopentadienyl-Ti-dichloride, di-cyclopentadienyl-Ti-bis-phenyl, di-cyclopentadienyl-Ti-bis-2,3,4,5,6-pentafluorophen-1-yl, di-cyclopentadienyl-Ti-bis-2,3,5,6-tetrafluorophen-1-yl, di-cyclopentadienyl-Ti-bis-2,4,6-trifluorophen-1-yl, di-cyclopentadienyl-Ti-bis-2,6-difluorophen-1-yl, di-cyclopentadienyl-Ti-bis-2-4-difluorophen-1-yl, di-methylcyclopentadienyl-Ti-bis-2,3,4,5,6-pentafluorophen-1-yl, di-methylcyclopentadienyl-Ti-bis-2,3,5,6-tetrafluorophen-1-yl, di-methylcyclopentadienyl-Ti-bis-2,4-difluorophen-1-yl, bis(cyclopentadienyl)-bis(2,6-difluoro-3-(pyr-1-yl)phenyl)titanium, and the like.

These polymerization initiators may be used alone or in combination of two or more.

The content of the polymerization initiator according to the invention is 1.0 to 0.01 mass %, preferably 0.5 to 0.05 mass %, with respect to the total solid matters in the coating solution.

### (Sensitization colorant)

The coating solution according to the invention preferably contains a sensitization colorant as well as the polymerization initiator.

The sensitization colorant is selected suitably according to the light source used during irradiation of the planographic printing plate prepared.

First, sensitization colorants having an absorption maximum in the wavelength range of 300 to 500 nm will be described.

Examples of the sensitization colorants include the merocyanine dyes represented by the following Formula (I), benzopyrans represented by the following Formula (II), coumarins, the aromatic ketones represented by the following Formula (III), the anthracenes represented by the following Formula (IV), and the like.

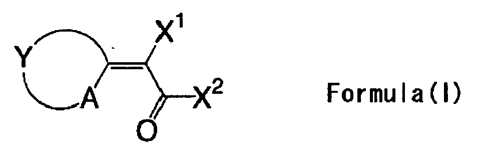

In Formula (I) above, A represents a S atom or NR⁶; R⁶ represents a monovalent non-metal atom group; Y represents a non-metal atom group forming a basic ring of the dye together with the neighboring A and the neighboring carbon atoms; X¹ and X² each independently represent a monovalent non-metal atom group; and X¹ and X² may bind to each other, forming an acidic ring of the dye.

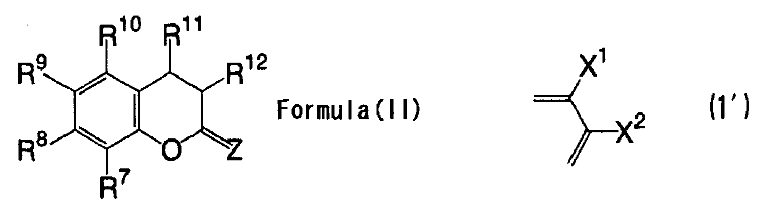

In Formula (II) above, =Z represents a carbonyl group, a thiocarbonyl group, an imino group, or an alkylidene group represented by partial structural Formula (1') above; X¹ and X² are the same as those in Formula (I); and R⁷to R¹² each independently represent a monovalent non-metal atom group.

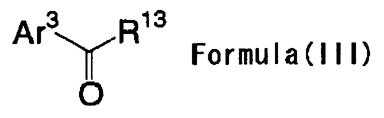

In Formula (III) above, Ar³ represents an aromatic or hetero aromatic group that may have one or more substituents; and R¹³ represents a monovalent non-metal atom group. More preferable, R¹³ is an aromatic or heteroaromatic group, and Ar³ and R¹³ may bind to each other, forming a ring.

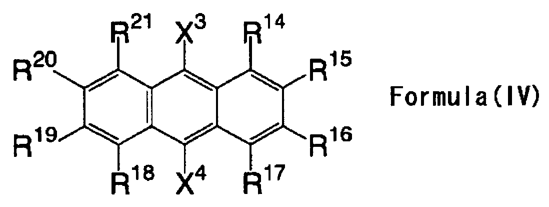

In Formula (IV) above, X³, X⁴, and R¹⁴ to R²¹ each independently represent a monovalent non-metal atom group; and more preferably, X³ and X⁴ each represent an electron-donating group having a negative Hammett substituent constant).

Favorable examples of the monovalent non-metal atom groups represented by X¹ to X⁴ or R⁶ to R²¹ in Formulae (I) to (IV) include a hydrogen atom, alkyl groups (such as methyl, ethyl, propyl, butyl, pentyl, hexyl, heptyl, octyl, nonyl, decyl, undecyl, dodecyl, tridecyl, hexadecyl, octadecyl, eicosyl, isopropyl, isobutyl, s-butyl, t-butyl, isopentyl, neopentyl, 1-methylbutyl, isohexyl, 2-ethylhexyl, 2-methylhexyl, cyclohexyl, cyclopentyl, 2-norbomyl, chloromethyl, bromomethyl, 2-chloroethyl, trifluoromethyl, methoxymethyl, methoxyethoxyethyl, allyloxymethyl, phenoxymethyl, methylthiomethyl, toluylthiomethyl, ethylaminoethyl, diethylaminopropyl, morpholino propyl, acetyloxymethyl, benzoyloxymethyl, N-cyclohexylcarbamoyloxyethyl, N-pheylcarbamoyloxyethyl, acetylaminoethyl, N-methylbenzoylaminopropyl, 2-oxoethyl, 2-oxopropyl, carboxypropyl, methoxycarbonylethyl, allyloxycarbonylbutyl, chlorophenoxycarbonylmethyl, carbamoylmethyl, N-methylcarbamoylethyl, N,N-dipropylcarbamoylmethyl, N-(methoxyphenyl)carbamoylethyl, N-methyl-N-(sulfo phenyl)carbamoylmethyl, sulfobutyl, sulfonatobutyl, sulfamoylbutyl, N-ethylsulfamoylmethyl, N,N-dipropylsulfamoylpropyl, N-toluylsulfamoylpropyl, N-methyl-N-(phosphonophenyl)sulfamoyloctyl, phosphonobutyl, phosphonatohexyl, diethylphosphonobutyl, diphenylphosphonopropyl, methylphosphonobutyl, methylphosphonatobutyl, toluylphosphonohexyl, toluylphosphonatohexyl, phosphonooxypropyl, phosphonatooxybutyl, benzyl, phenethyl, α-methylbenzyl, 1-methyl-1-phenylethyl, p-methylbenzyl, cinnamyl, allyl, 1-propenylmethyl, 2-butenyl, 2-methyl allyl, 2-methylpropenylmethyl, 2-propynyl, 2-butynyl, and 3-butynyl groups), aryl groups (such as phenyl, biphenyl, naphthyl, toluyl, xylyl, mesityl, cumenyl, chlorophenyl, bromophenyl, chloromethylphenyl, hydroxyphenyl, methoxyphenyl, ethoxyphenyl, phenoxyphenyl, acetoxyphenyl, benzoyloxyphenyl, methylthiophenyl, phenylthiophenyl, methylaminophenyl, dimethylaminophenyl, acetylaminophenyl, carboxyphenyl, methoxycarbonylphenyl, ethoxyphenylcarbonyl, phenoxycarbonylphenyl, N-pheylcarbamoylphenyl, phenyl, cyanophenyl, sulfo phenyl, sulfonatophenyl, phosphonophenyl, and phosphonatophenyl groups), heteroaryl groups (such as thiophene, furan, pyran, isobenzofuran, chromane, xanthene, phenoxazine, pyrrole, pyrazole, isothiazole, isoxazole, pyrazine, pyrimidine, pyridazine, indolidine, isoindolidine, indazole, purine, quinolizine, isoquinoline, phthalazine, naphthyridine, quinazoline, sinoline, pteridine, carbazole, carboline, phenanthrene, acridine, perimidine, phenanthroline, phthalazine, phenarsazine, phenoxazine, furazan, and phenoxazine groups), alkenyl groups (such as vinyl, 1-propenyl, 1-butenyl, cinnamyl, and 2-chloro-1-ethenyl groups), alkynyl groups (such as ethynyl, 1-propynyl, 1-butynyl, and trimethylsilylethynyl groups), halogen atoms (-F, -Br, -Cl, and -I), a hydroxyl group, alkoxy groups, aryloxy groups, a mercapto group, alkylthio groups, arylthio groups, alkyldithio groups, aryldithio groups, an amino group, N-alkylamino groups, N,N-dialkylamino groups, N-arylamino groups, N,N-diarylamino groups, N-alkyl-N-arylamino groups, acyloxy groups, a carbamoyloxy group, N-alkylcarbamoyloxy groups, N-arylcarbamoyloxy groups, N,N-dialkylcarbamoyloxy groups, N,N-diarylcarbamoyloxy groups, N-alkyl-N-arylcarbamoyloxy groups, alkylsulfoxy groups, arylsulfoxy groups, acylthio groups, acylamino groups, N-alkylacylamino groups, N-arylacylamino groups, a ureido group, N'-alkylureido groups, N,N'-dialkylureido group, N'-arylureido groups, N,N'-diarylureido groups, N'-alkyl-N'-arylureido groups, N-alkylureido groups, N-arylureido groups, N'-alkyl-N-alkylureido groups, N'-alkyl-N-arylureido groups, N,N'-dialkyl-N-alkylureido groups, N,N'-dialkyl-N-arylureido groups, N'-aryl-N-alkylureido groups, N'-aryl-N-arylureido groups, N,N'-diaryl-N-alkylureido groups, N',N'-diaryl-N-arylureido groups, N'-alkyl-N'-aryl-N-alkylureido groups, N'-alkyl-N'-aryl-N-arylureido groups, alkoxycarbonylamino groups, aryloxycarbonylamino groups, N-alkyl-N-alkoxycarbonylamino groups, N-alkyl-N-aryloxycarbonylamino groups, N-aryl-N-alkoxycarbonylamino groups, N-aryl-N-aryloxycarbonylamino groups, a formyl group, acyl groups, a carboxyl group, alkoxycarbonyl groups, aryloxycarbonyl groups, carbamoyl groups, N-alkylcarbamoyl groups, N,N-dialkylcarbamoyl groups, N-arylcarbamoyl groups, N,N-diarylcarbamoyl groups, N-alkyl-N-arylcarbamoyl groups, alkylsulfinyl groups, arylsulfinyl groups, alkylsulfonyl groups, arylsulfonyl groups, a sulfo group (-SO₃H) and the conjugate base groups thereof (hereinafter, referred to as sulfonato groups), alkoxysulfonyl groups, aryloxysulfonyl groups, a sulfinamoyl group, N-alkylsulfinamoyl groups, N,N-dialkylsulfinamoyl groups, N-arylsulfinamoyl groups, N,N-diarylsulfinamoyl groups, N-alkyl-N-arylsulfinamoyl groups, a sulfamoyl group, N-alkylsulfamoyl groups, N,N-dialkylsulfamoyl groups, N-arylsulfamoyl groups, N,N-diarylsulfamoyl groups, N-alkyl-N-arylsulfamoyl groups, a phosphono group (-PO₃H₂) and the conjugate base groups thereof (hereinafter, referred to as phosphonato groups), dialkylphosphono groups (-PO₃(alkyl)₂), diarylphosphono groups (-PO₃(aryl)₂), alkylarylphosphono groups (-PO₃(alkyl)(aryl)), monoalkylphosphono groups (-PO₃H(alkyl)) and the conjugate base groups thereof (hereinafter, referred to as alkylphosphonato groups), monoarylphosphono groups (-PO₃H(aryl)) and the conjugate base groups thereof (hereinafter, referred to as arylphosphonato groups), a phosphonooxy group (-OPO₃H₂) and the conjugate base groups thereof (hereinafter, referred to as phosphonatooxy groups), dialkylphosphonooxy groups (-OPO₃(alkyl)₂), diarylphosphonooxy groups (-OPO₃(aryl)₂), alkylarylphosphonooxy groups (-OPO₃(alkyl)(aryl)), monoalkylphosphonooxy groups (-OPO₃H(alkyl)) and the conjugate base groups thereof (hereinafter, referred to as alkylphosphonatooxy groups), monoarylphosphonooxy groups (-OPO₃H(aryl)) and the conjugate base groups thereof (hereinafter, referred to as arylphosphonatooxy groups), a cyano group, a nitro group, and the like; and, among the substituent groups above, a hydrogen atom, alkyl groups, aryl groups, halogen atoms, alkoxy groups, and acyl groups are particularly preferable.

The basic ring of the dye that Y in Formula (I) forms together with the neighboring A and the neighboring carbon atoms is, for example, a five-, six-, or seven-membered nitrogen- or sulfur-containing heterocyclic ring, preferably a five- or six-membered heterocyclic ring.

Favorable examples of the nitrogen-containing heterocyclic rings include the basic rings of the merocyanine dyes described in L. G. Brooker et al., J. Am. Chem. Soc., 73, 5326-5358 (1951) and the reference literatures therein. Typical examples thereof include thiazoles (such as thiazole, 4-methylthiazole, 4-phenylthiazole, 5-methylthiazole, 5-phenylthiazole, 4,5-dimethylthiazole, 4,5-diphenylthiazole, 4,5-di(p-methoxyphenylthiazole), and 4-(2-thienyl)thiazole), benzothiazoles (such as benzothiazole, 4-chlorobenzothiazole, 5-chlorobenzothiazole, 6-chlorobenzothiazole, 7-chlorobenzothiazole, 4-methylbenzothiazole, 5-methylbenzothiazole, 6-methylbenzothiazole, 5-bromobenzothiazole, 4-phenylbenzothiazole, 5-phenylbenzothiazole, 4-methoxybenzothiazole, 5-methoxybenzothiazole, 6-methoxybenzothiazole, 5-iodobenzothiazole, 6-iodobenzothiazole, 4-ethoxybenzothiazole, 5-ethoxybenzothiazole, tetrahydrobenzothiazole, 5,6-dimethoxybenzothiazole, 5,6-dioxymethylene-benzothiazole, 5-hydroxybenzothiazole, 6-hydroxybenzothiazole, 6-dimethylaminobenzothiazole, and 5-ethoxycarbonylbenzothiazole), naphthothiazoles (such as naphtho[1,2]thiazole, naphtho[2,1]thiazole, 5-methoxynaphtho[2,1]thiazole, 5-ethoxynaphtho[2,1]thiazole, 8-methoxynaphtho[1,2]thiazole, and 7-methoxynaphtho[1,2]thiazole), thianaphtheno-7',6',4,5-thiazoles (such as 4'-methoxy-thianaphtheno-7',6',4,5-thiazole), oxazoles (such as 4-methyloxazole, 5-methyloxazole, 4-phenyloxazole, 4,5-diphenyloxazole, 4-ethyloxazole, 4,5-dimethyloxazole, and 5-phenyloxazole), benzoxazoles (such as benzoxazole, 5-chlorobenzoxazole, 5-methylbenzoxazole, 5-phenylbenzoxazole, 6-methylbenzoxazole, 5,6-dimethylbenzoxazole, 4,6-dimethylbenzoxazole, 6-methoxybenzoxazole, 5-methoxybenzoxazole, 4-ethoxybenzoxazole, 5-chlorobenzoxazole, 6-methoxybenzoxazole, 5-hydroxybenzoxazole, and 6-hydroxybenzoxazole), naphthoxazoles (such as naphtho[1,2]oxazole and naphtho[2,1]oxazole), selenazoles (such as 4-methylselenazole and 4-phenylselenazole), benzoselenazoles (such as example, benzoselenazole, 5-chlorobenzoselenazole, 5-methoxybenzoselenazole, 5-hydroxybenzoselenazole, and tetrahydrobenzoselenazole), naphthoselenazoles (such as example, naphtho[1,2]selenazole and naphtho[2,1]selenazole), thiazolines (such as thiazoline and 4-methylthiazoline), 2-quinolines (such as quinoline, 3-methylquinoline, 5-methylquinoline, 7-methylquinoline, 8-methylquinoline, 6-chloroquinoline, 8-chloroquinoline, 6-methoxyquinoline, 6-ethoxyquinoline, 6-hydroxyquinoline, and 8-hydroxyquinoline), 4-quinolines (such as quinoline, 6-methoxyquinoline, 7-methylquinoline, and 8-methylquinoline), 1-isoquinolines (such as isoquinoline and 3,4-dihydroisoquinoline), 3-isoquinolines (such as isoquinoline), benzimidazoles (such as 1,3-diethylbenzimidazole and 1-ethyl-3-phenylbenzimidazole), 3,3-dialkylindolenines (such as 3,3-dimethylindolenine, 3,3,5-trimethylindolenine, and 3,3,7-trimethylindolenine), 2-pyridines (such as 2-pyridine and 5-methyl-2-pyridine), 4-pyridines (such as 4-pyridine), and the like.

Examples of the sulfur-containing heterocyclic rings include the dithiol partial structures of the dyes described in JP-A No. 3-296759.

Typical examples thereof include benzodithiols (such as benzodithiol, 5-t-butylbenzodithiol, and 5-methylbenzodithiol), naphthodithiols (such as naphtho[1,2]dithiol and naphtho[2,1]dithiol), dithiols (such as 4,5-dimethyldithiols, 4-phenyldithiols, 4-methoxycarbonyldithiols, 4,5-dimethoxycarbonylbenzodithiols, 4,5-ditrifluoromethyldithiol, 4,5-dicyanodithiol, 4-methoxycarbonylmethyldithiol, and 4-carboxymethyldithiol), and the like.

The name of the basic skeleton of the heterocyclic ring was used in description of the heterocyclic ring described above for convenience, but the basic skeleton, when it constitutes the partial structure of the basic skeleton of the sensitization colorant, is introduced in the form of an alkylidene-type substituent group having a lower unsaturation degree, for example, as a 3-substituted-2(3H)-benzothiazolylidene group in the case of a benzothiazole skeleton.

Among the sensitization colorants having an absorption maximum in the wavelength range of 360 nm to 450 nm, preferably from the viewpoint of sensitivity are the dyes represented by the following Formula (V).

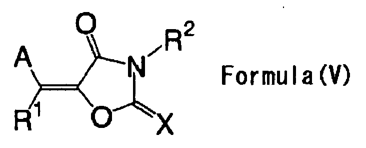

In Formula (V) above, A represents an aromatic or hetero ring that may be substituted; and X represents an oxygen or sulfur atom, or N-(R³). R¹, R² and R³ each independently represent a hydrogen atom or a monovalent non-metal atom group; and A and R¹ or R² and R³ may bind to each other, forming an aliphatic or aromatic ring.

The compounds represented by Formula (V) will be described in more detail. R¹, R² and R³ each independently represent a hydrogen atom or a monovalent non-metal atom group, preferably a substituted or unsubstituted alkyl group, a substituted or unsubstituted alkenyl group, a substituted or unsubstituted aryl group, a substituted or unsubstituted aromatic heterocyclic ring residue, a substituted or unsubstituted alkoxy group, a substituted or unsubstituted alkylthio group, a hydroxyl group, or a halogen atom.

Typical favorable examples of the R¹, R² and R³ will be described below. Favorable examples of the alkyl groups include straight-chain, branched, and cyclic alkyl groups having 1 to 20 carbon atoms; and typical examples thereon include methyl, ethyl, propyl, butyl, pentyl, hexyl, heptyl, octyl, nonyl, decyl, undecyl, dodecyl, tridecyl, hexadecyl, octadecyl, eicosyl, isopropyl, isobutyl, s-butyl, t-butyl, isopentyl, neopentyl, 1-methylbutyl, isohexyl, 2-ethylhexyl, 2-methylhexyl, cyclohexyl, cyclopentyl, and 2-norbomyl groups. Among them, straight-chain alkyl groups having 1 to 12 carbon atoms, branched alkyl groups having 3 to 12 carbon atoms, and cyclic alkyl groups having 5 to 10 carbon atoms are more preferable.

Examples of the heteroaryl groups favorable as R¹, R² and R³ include monocyclic or polycyclic aromatic rings containing at least one nitrogen, oxygen, or sulfur atom, and particularly favorable examples of the heteroaryl groups include thiophene, furan, pyran, isobenzofuran, chromane, xanthene, phenoxazine, pyrrole, pyrazole, isothiazole, isoxazole, pyrazine, pyrimidine, pyridazine, indolidine, isoindolidine, indazole, purine, quinolizine, isoquinoline, phthalazine, naphthyridine, quinazoline, sinoline, pteridine, carbazole, carboline, phenanthrene, acridine, perimidine, phenanthroline, phthalazine, phenarsazine, phenoxazine, furazan, phenoxazine, and the like; and these rings may be fused with a benzene ring or may have one or more substituents.

Typical examples of the aryl groups favorable as R¹, R² and R³ include aryl groups fused with one to three benzene rings and those in which a benzene ring and a five-membered unsaturated ring form a fused ring; and typical examples thereof include phenyl, naphthyl, anthryl, phenanthryl, indenyl, acenaphthenyl, and fluorenyl groups; and among them, phenyl and naphthyl groups are more preferable.

A in Formula (V) will be described below. A represents an aromatic or hetero ring that may be substituted; and typical examples of the aromatic or heterocyclic rings that may be substituted include those similar to the rings represented by R¹, R² and R³ in Formula (V).

The sensitization colorant represented by Formula (V) of the invention can be prepared in condensation reaction of an acidic ring or an active methylene group-containing acidic ring described above with a substituted or unsubstituted aromatic or heterocyclic ring, according to the method described in JP-B No. 59-28329.

Typical favorable examples of the compounds represented by Formula (V) are listed below. The compound is not limited to only one of the isomers present due to the double bond connecting the acidic ring with the basic ring.

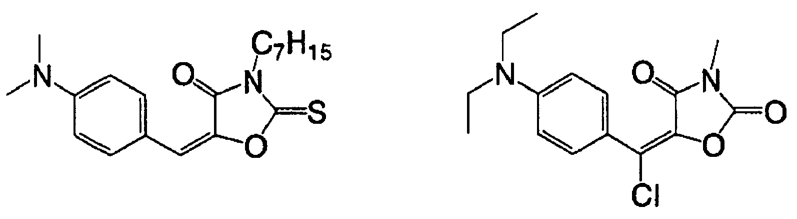

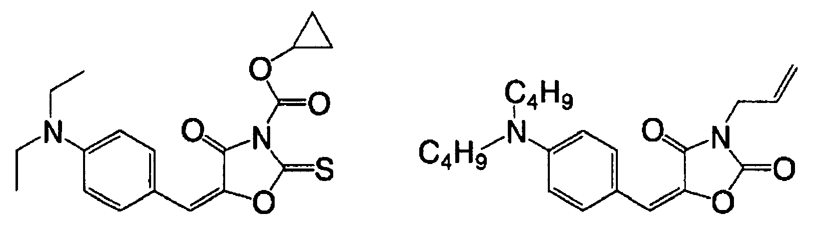

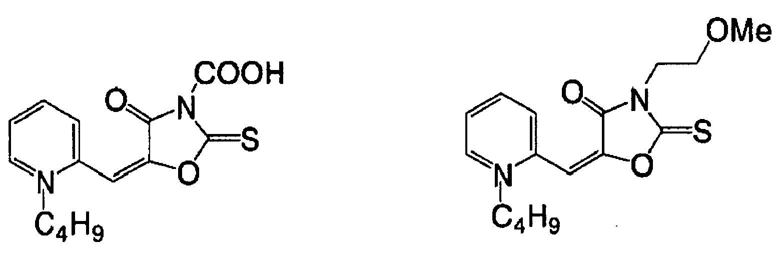

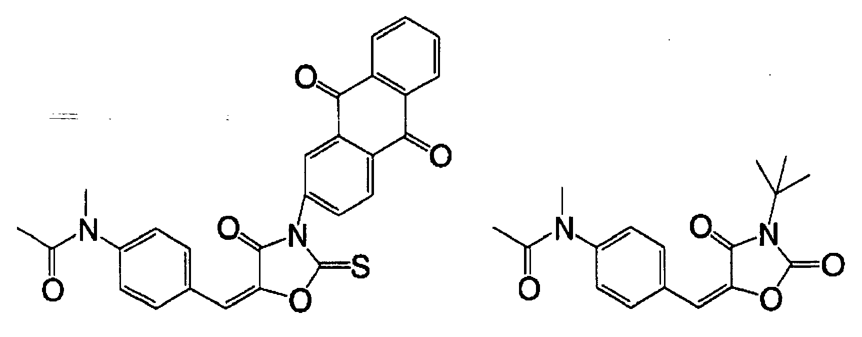

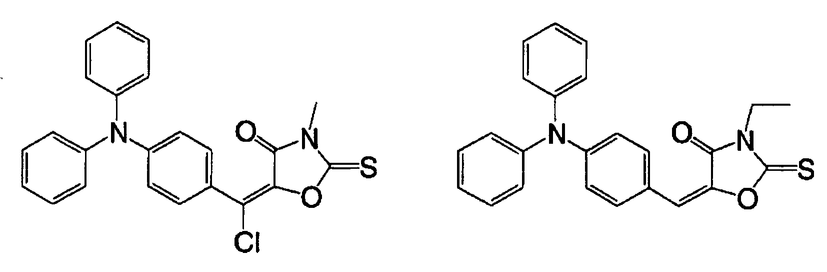

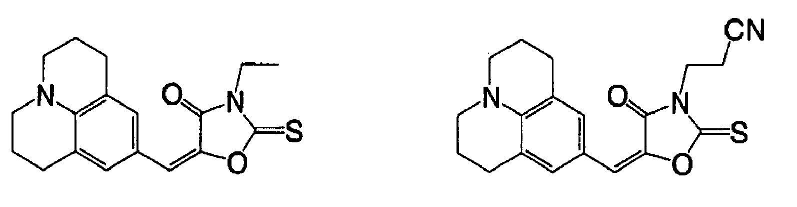

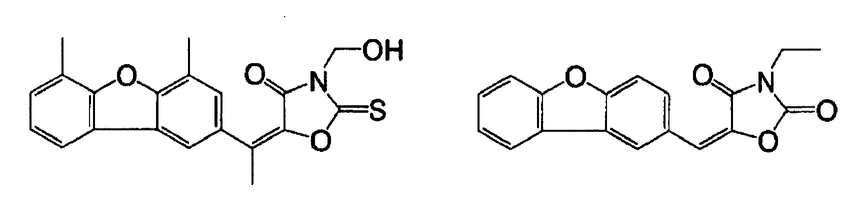

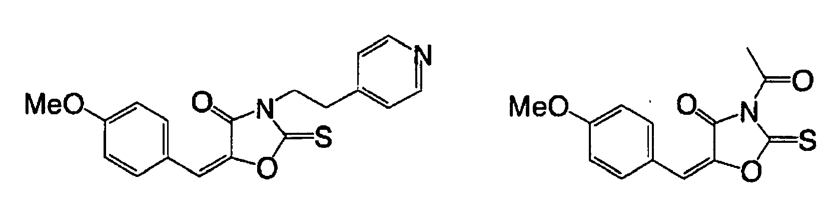

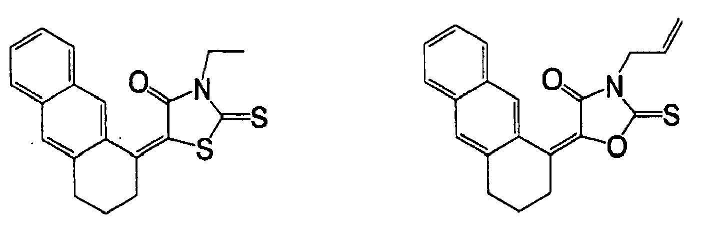

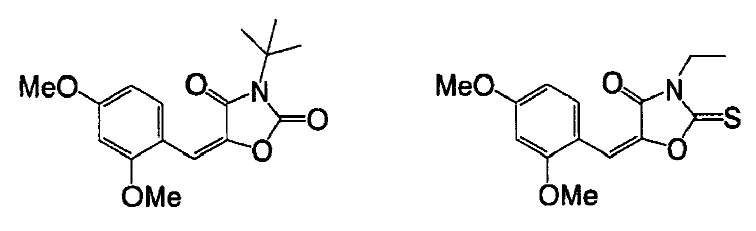

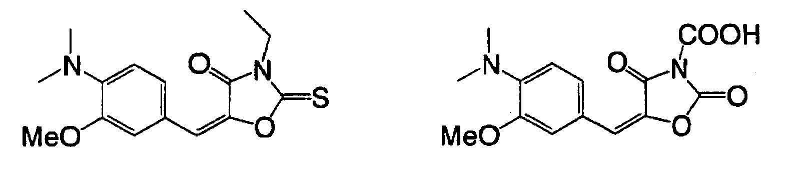

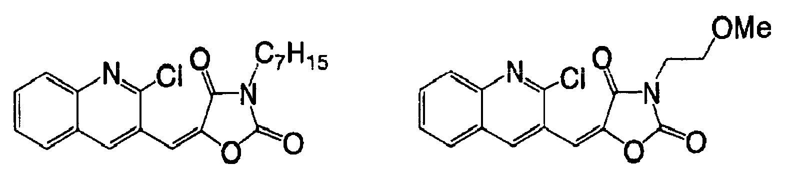

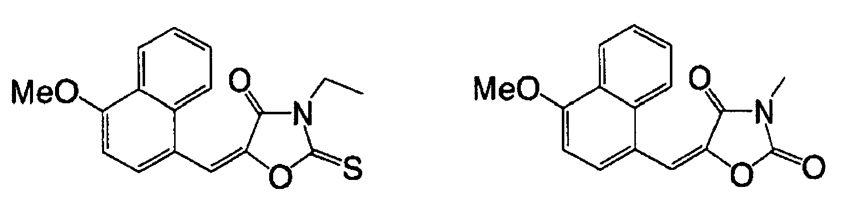

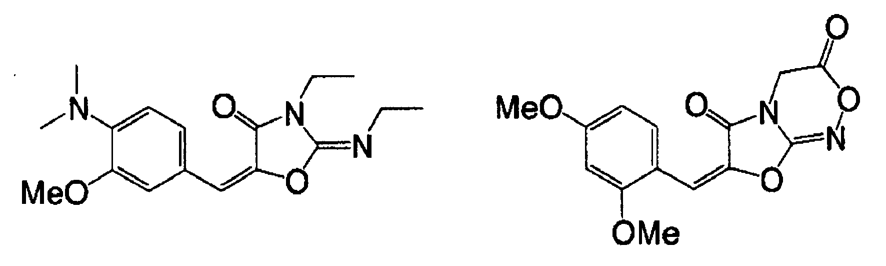

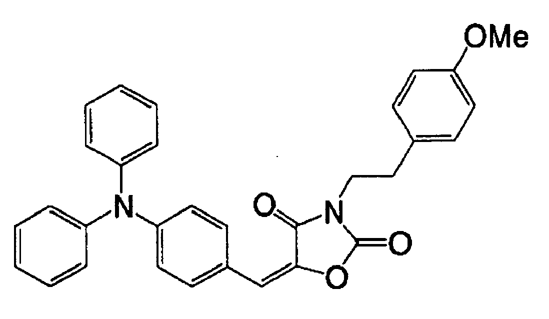

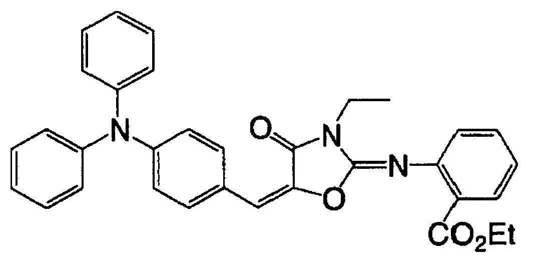

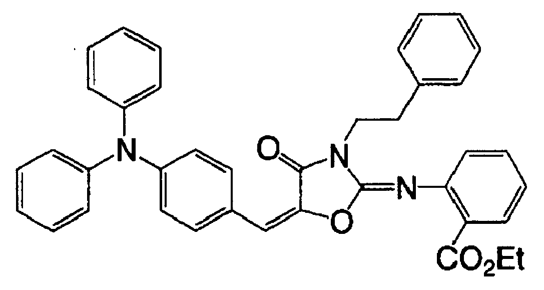

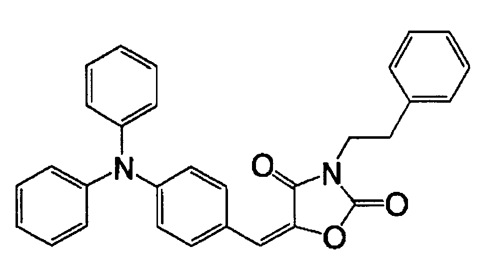

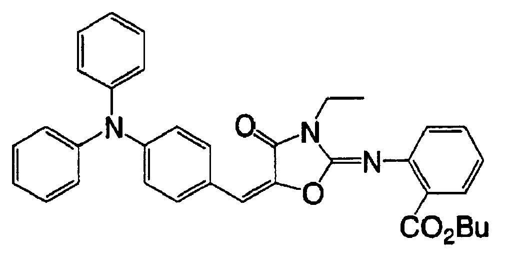

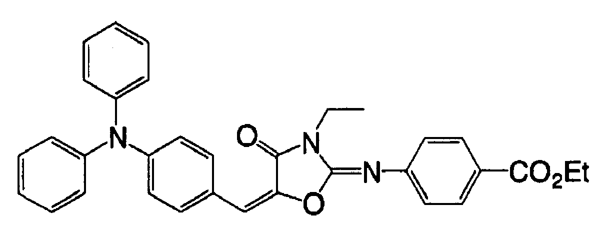

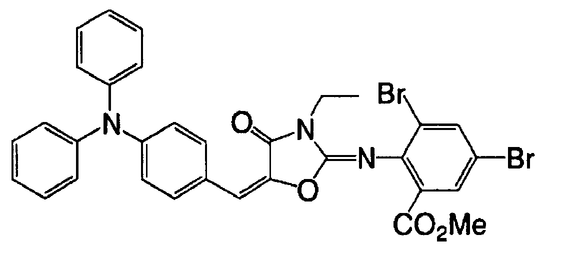

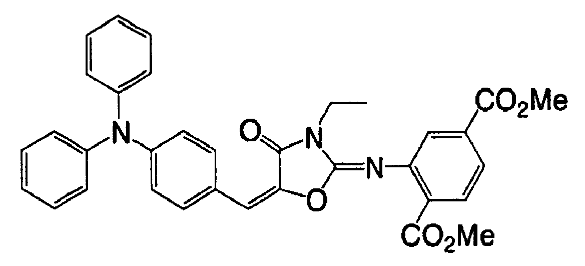

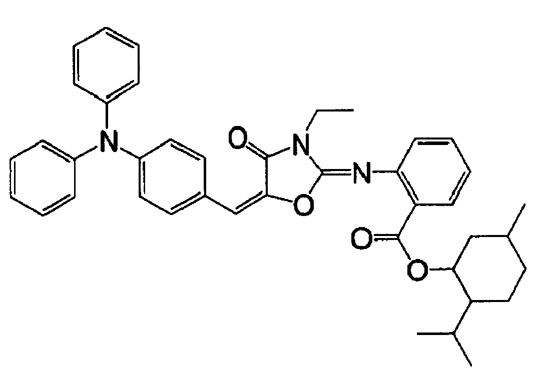

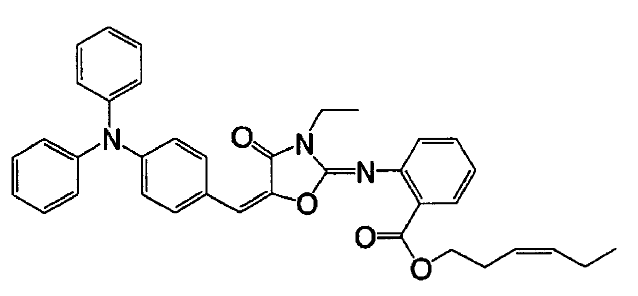

The sensitization colorants according to the invention may also be used alone or in combination of two or more.

The content the sensitization colorant in the invention is normally, in the range of 0.05 to 30 parts by mass, preferably 0.1 to 20 parts by mass, more preferably 0.2 to 10 parts by mass, with respect to 100 parts by mass of the total solid matters in the coating solution.

### (Coinitiator)

The coating solution according to the invention may also contain a coinitiator for improvement in sensitivity. Examples of the coinitiators include halogenated hydrocarbon derivatives, ketone compounds, ketoxime compounds, organic peroxides, thio compounds, hexaarylbiimidazoles, aromatic onium salts, oxime ethers, and the like.

These coinitiators may be used alone or in combination of two or more.

The amount of the coinitiator is 0.1 to 50 mass %, preferably 0.5 to 30 mass %, with respect to the total solid matters in the coating solution.

### (Polymerization inhibitor)

A small amount of polymerization inhibitor is added to the coating solution according to the invention during preparation or storage of the coating solution, for the purpose of preventing undesirable thermal polymerization of the addition-polymerizable compound.

Examples of the polymerization inhibitors favorably used in the invention include hydroquinone, p-methoxyphenol, di-t-butyl-p-cresol, pyrogallol, t-butylcatechol, benzoquinone, 4,4'-thiobis(3-methyl-6-t-butylphenol), 2,2'-methylene bis(4-methyl-6-t-butylphenol), N-nitrosophenylhydroxyamine aluminum salt, N-nitrosophenylhydroxyamine cerous salt, and the like.

These polymerization inhibitors may be used alone or in combination of two or more.

The amount of the polymerization inhibitor added in the invention is preferably, approximately 0.01 mass % to approximately 5 mass %, with respect to the total solid matters in the coating solution.

### (Binder polymer)

The coating solution according to the invention preferably contains a binder polymer for improvement in the properties of the photosensitive layer.

Any one of known binder polymers may be used as the binder polymer without restriction, and linear organic polymers are preferable. Examples of the binder polymers include acrylic resins, polyvinylacetal resins, polyurethane resins, polyurea resins, polyimide resins, polyamide resins, epoxy resins, methacrylic resins, polystyrene resins, novolak phenol resins, polyester resins, synthetic rubbers, and natural rubbers.

The binder polymer is preferably crosslinkable, for improvement in the film strength of the image region. A crosslinkable functional group such as ethylenic unsaturated bond is introduced onto the main or side chain of the polymer, to make the binder polymer crosslinkable. The crosslinkable functional group may be introduced by copolymerization or in polymer reaction.

The crosslinkable group is a group that crosslinks the binder polymer in the process of radical polymerization reaction occurring in the photosensitive layer when the planographic printing plate precursor is exposed to light. The crosslinking group is not particularly limited if it has such a function, and examples of the addition-polymerizable functional groups include ethylenic unsaturated bond groups, amino groups, epoxy groups, and the like. The crosslinking group may be a functional group that gives a radical species by photoirradiation, and examples the crosslinkable groups include a thiol group, halogen groups, onium salt structures, and the like. Among them, ethylenic unsaturated bond groups are preferable, and particularly preferable are the functional groups represented by the following Formulae (1) to (3).

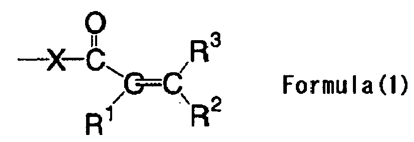

In Formula (1) above, R¹ to R³ each independently represent a monovalent organic group; and R¹ is preferably a hydrogen atom, an alkyl group that may be substituted, or the like, and in particular, a hydrogen atom or a methyl group, because it is higher in radical reactivity.

R² and R³ each independently represent a hydrogen or halogen atom, or an amino, carboxyl, alkoxycarbonyl, sulfo, nitro, or cyano group, an alkyl group that may be substituted, an aryl group that may be substituted, an alkoxy group that may be substituted, an aryloxy group that may be substituted, an alkylamino group that may be substituted, an arylamino group that may be substituted, an alkylsulfonyl group that may be substituted, an arylsulfonyl group that may be substituted, or the like; and more preferably a hydrogen atom, a carboxyl group, an alkoxycarbonyl group, an alkyl group that may be substituted, or an aryl group that may be substituted, because it is higher in radical reactivity.

X represents an oxygen or sulfur atom, or -N(R¹²)-; and R¹² represents a hydrogen atom or a monovalent organic group. R¹² is, for example, an alkyl group that may be substituted, and particularly preferably a hydrogen atom or a methyl, ethyl, or isopropyl group, because it is higher in radical reactivity.

Examples of the substituent groups that may be introduced thereon include alkyl groups, alkenyl groups, alkynyl groups, aryl groups, alkoxy groups, aryloxy groups, halogen atoms, amino groups, alkylamino groups, arylamino groups, carboxyl groups, alkoxycarbonyl groups, sulfo groups, a nitro group, a cyano group, amido groups, alkylsulfonyl groups, arylsulfonyl groups, and the like.

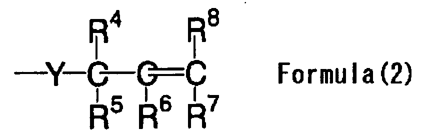

In Formula (2) above, R⁴ to R⁸ each independently represent a monovalent organic group; each of R⁴ to R⁸ is preferably, a hydrogen or halogen atom, an amino, dialkylamino, carboxyl, alkoxycarbonyl, sulfo, nitro, or cyano group, an alkyl group that may be substituted, an aryl group that may be substituted, an alkoxy group that may be substituted, an aryloxy group that may be substituted, an alkylamino group that may be substituted, an arylamino group that may be substituted, an alkylsulfonyl group that may be substituted, an arylsulfonyl group that may be substituted, or the like; and particular preferably, a hydrogen atom, a carboxyl group, an alkoxycarbonyl group, an alkyl group that may be substituted, or an aryl group that may be substituted.

Examples of the substituent groups that may be substituted include substituents similar to those in Formula (1). Y represents an oxygen or sulfur atom, or -N (R¹²)-, R¹² is the same as R¹² in Formula (1), and the favorable example are also the same.

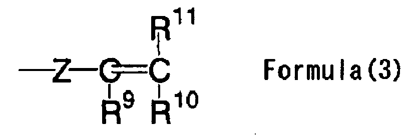

In Formula (3) above, R⁹ is preferably a hydrogen atom, an alkyl group that may be substituted, or the like, and particularly preferably, a hydrogen atom and methyl group, because it is higher in radical reactivity preferable. R¹⁰ and R¹¹ each independently represent a hydrogen or halogen atom, or an amino, dialkylamino, carboxyl, alkoxycarbonyl, sulfo, nitro, or cyano group, an alkyl group that may be substituted, an aryl group that may be substituted, an alkoxy group that may be substituted, an aryloxy group that may be substituted, an alkylamino group that may be substituted, an arylamino group that may be substituted, an alkylsulfonyl group that may be substituted, an arylsulfonyl group that may be substituted, or the like; and more preferably, a hydrogen atom, a carboxyl group, an alkoxycarbonyl group, an alkyl group that may be substituted, or an aryl group that may be substituted, because it is higher in radical reactivity.

Examples of the substituent groups that may be introduced include substituents similar to those in Formula (1). Z represents an oxygen or sulfur atom, -N (R¹³)-, or a phenylene group that may be substituted.

R¹³ is, for example, an alkyl group that may be substituted, and preferably, a methyl, ethyl or isopropyl group, because it is higher in radical reactivity.

The binder polymer having a crosslinkable group on the side chain according to the invention, which should function as a film-forming agent for the photosensitive layer and also be soluble in the developing solution (preferably alkaline developing solution), is preferably an organic polymer soluble or swelling in aqueous alkaline solution. Thus, the binder polymer according to the invention preferably has an alkali-solubilizing group, for example carboxyl group, on the side chain in addition to the crosslinkable group.

The binder polymer having a crosslinkable group on the side chain can be developed with water, if it is a water-soluble organic polymer.

Examples of the binder polymers according to the invention include those described in JP-ANos. 59-53836 and 59-71048, i.e., (meth)acrylate copolymers, itaconate copolymers, crotonate copolymers, maleate copolymers, partially esterified maleate copolymers having a crosslinkable group such as allyl or (meth)acryloyl on the side chain, and the like.

Polyurethanes, acidic cellulose derivatives, and adducts of a hydroxyl group-containing addition polymer with a cyclic anhydride similarly having a crosslinkable group and a carboxyl group on the side chain are also useful as the binder polymers according to the invention.

Among them, (meth)acrylate copolymers and polyurethanes are more preferable. Polyurethane resins are particularly preferable, because they can reduce the development damage in the exposed portion without decrease in the developing efficiency of the unexposed portion and have favorable staining resistance as well as high printing durability, even when the photosensitive layer has a lower acid value.

Hereinafter, the polyurethanes resin having a crosslinkable group on the side chain will be described in more detail.

The polyurethane resin having a crosslinkable group on the side chain particularly favorably used in the invention is prepared in polyaddition reaction of (i) a diisocyanate compound, (ii) a diol compound having a carboxyl group, and (iii) a crosslinkable group-containing diisocyanate compound, together with (iv) a diol compound having no carboxyl group if needed.

Hereinafter, raw materials for the polyurethane resin, diisocyanate and diol compound, will be described.

### (i) Diisocyanate compound

Examples of the diisocyanate compounds include diisocyanate compounds represented by Formula (4).

OCN-L-NCO Formula (4)

In Formula (4), L represents a bivalent aliphatic or aromatic hydrocarbon group that may have one or more substituents.

L may have another functional group unreactive with the isocyanate group such as a carbonyl, ester, urethane, amido, or ureido group as needed. More specifically, L represents a single bond or a bivalent aliphatic or aromatic hydrocarbon group that may have one or more substituent groups (such as alkyl, aralkyl, aryl, alkoxy, or halogeno group). L is preferably an alkylene group having 1 to 20 carbon atoms, an arylene group having 6 to 15 carbon atoms, and more preferably an alkylene group having 1 to 8 carbon atoms. L may also have as needed another functional group unreactive with the isocyanate group such as a carbonyl, ester, urethane, amido, ureido, or ether group.

Typical examples thereof include the followings: aromatic diisocyanate compounds such as 2,4-tolylene diisocyanate, 2,4-tolylene diisocyanate dimer, 2,6-tolylene diisocyanate, p-xylylene diisocyanate, m-xylylene diisocyanate, 4,4'-diphenylmethane diisocyanate, 1,5-naphthylene diisocyanate, and 3,3'-dimethylbiphenyl-4,4'-diisocyanate; aliphatic diisocyanate compounds such as hexamethylene diisocyanate, trimethylhexamethylene diisocyanate, lysine diisocyanate, and dimer acid diisocyanate; alicyclic diisocyanate compounds such as isophorone diisocyanate, 4,4'- methylenebis(cyclohexylisocyanate), methylcyclohexane-2,4 (or 2,6) diisocyanate, and 1,3-(isocyanatomethyl)cyclohexane; diisocyanate compounds prepared in reaction of a diol and a diisocyanate such as the isocyanate from 1 mole of 1,3-butylene glycol and 2 mole of tolylene diisocyanate; and the like.

The diisocyanate compounds may be used alone or in combination of two or more. From the point of the balance between staining resistance and printing durability, it is preferable to use the compounds in combination of two or more and particularly preferable to use at least one aromatic diisocyanate compound (L is an aromatic group) and at least one aliphatic diisocyanate compound (L is an aliphatic group).

The amount of the diisocyanates used is preferably 0.8 to 1.2, more preferably 0.9 to 1.1 by molar ratio with respect to the diol compound. When the diisocyanate compounds are used in an amount excess with respect to diol compound and the isocyanate groups remain reactive on the polymer terminals, it is preferable to prepare a polyurethane resin having no reactive isocyanate group, by treating the resin after polymerization reaction with an alcohol, amine, or the like.

### (ii) Diol compound having at least one carboxyl group

Examples of the diol compounds having at least one carboxyl group include the compounds represented by the following Formulae (5), (6), and (7) and/or the compounds obtained by ring-opening of a tetracarboxylic dianhydride with a diol compound. Also included are the diol compounds used for ring opening of the carboxylic dianhydrides.

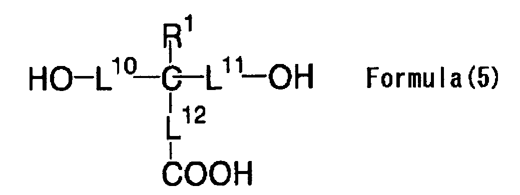

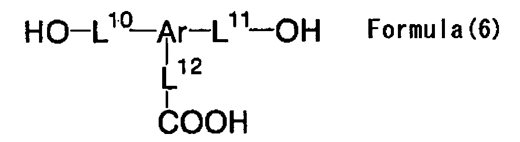

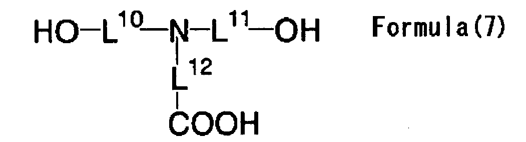

In the Formula, R¹ represents a hydrogen atom, an alkyl, aralkyl, aryl, alkoxy, or aryloxy group that may have one or more substituent groups (such as cyano, nitro, a halogen atom (-F, -Cl, -Br, or -I), -CONH₂, -COOR¹¹³, -OR¹¹³, -NHCONHR¹¹³, -NHCOOR¹¹³, -NHCOR¹¹³, -OCONHR¹¹³ (wherein, R¹¹³ represents an alkyl group having 1 to 10 carbon atoms or an aralkyl group having 7 to 15 carbon atoms), and preferably a hydrogen atom, an alkyl group having 1 to 8 carbon atoms, or an aryl group having 6 to 15 carbon atoms. L¹⁰, L¹¹, and L¹² each independently represent a single bond or a bivalent aliphatic or aromatic hydrocarbon group that may have one or more substituent groups (preferably such as alkyl, aralkyl, aryl, alkoxy, or halogeno group), preferably an alkylene group having 1 to 20 carbon atoms or an arylene group having 6 to 15 carbon atoms, and more preferably an alkylene group having 1 to 8 carbon atoms. L¹⁰, L¹¹, and L¹² may have another functional group unreactive with the isocyanate group such as a carbonyl, ester, urethane, amido, ureido, or ether group as needed. Two or three of R¹, L¹⁰, L¹¹, and L¹² may bind to each other, forming a ring. Ar represents a trivalent aromatic hydrocarbon group that may have one or more substituents, preferably an aromatic group having 6 to 15 carbon atoms.

Typical examples of the diol compound represented by Formula (5), (6) or (7) include the followings:
3,5-dihydroxybenzoic acid, 2,2-bis(hydroxymethyl)propionic acid, 2,2-bis(2-hydroxyethyl)propionic acid, 2,2-bis(3-hydroxypropyl)propionic acid, bis(hydroxymethyl)acetic acid, bis(4-hydroxyphenyl)acetic acid, 2,2-bis(hydroxymethyl)butyric acid, 4,4-bis(4-hydroxyphenyl)pentanoic acid, tartaric acid, N,N-dihydroxyethyl glycine, N,N-bis(2-hydroxyethyl)-3-carboxy-propionamide, and the like.

Favorable examples of the tetracarboxylic dianhydrides used in preparation of at least one diol compound having at least one carboxyl group include the compounds represented by the following Formulae (8), (9), and (10).

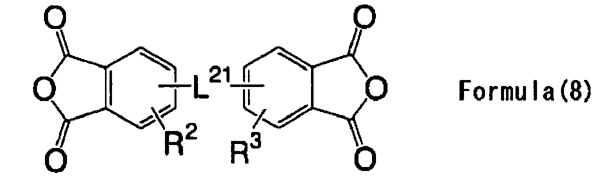

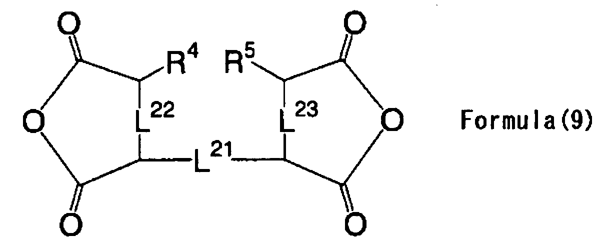

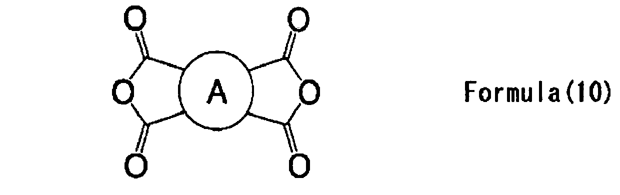

In the Formula, L²¹ represents a single bond, a bivalent aliphatic or aromatic hydrocarbon group that may have one or more substituent groups (preferably such as alkyl, aralkyl, aryl, alkoxy, halogeno, ester, or amido), -CO-, -SO-, -SO₂ -, -O- or -S-, preferably a single bond, a bivalent aliphatic hydrocarbon group having 1 to 15 carbon atoms, -CO-, -SO₂ -, -O- or -S-. R² and R³ each independently represent a hydrogen atom or an alkyl, aralkyl, aryl, alkoxy, or halogeno group, preferably, a hydrogen atom, an alkyl group having 1 to 8 carbon atoms, an aryl group having 6 to 15 carbon atoms, an alkoxy group having 1 to 8 carbon atoms, or a halogeno group. Two of L²¹ , R² and R³ may bind to each other, forming a ring. R⁴ and R⁵ each independent represent a hydrogen atom or an alkyl, aralkyl, aryl or halogeno group, preferably a hydrogen atom, an alkyl group having 1 to 8 carbon atoms, or an aryl group having 6 to 15 carbon atoms. Two of L²¹ , R⁴, and R⁵ may bind to each other, forming a ring. L²² and L²³ each independently represent a single bond, a double bond, or a bivalent aliphatic hydrocarbon group, preferably a single bond, a double bond, or a methylene group. A represents a mononuclear or polynuclear aromatic ring, preferably an aromatic ring having 6 to 18 carbon atoms.

Typical examples of the compounds represented by Formulae (8), (9) and (10) include the followings: aromatic tetracarboxylic dianhydrides such as pyromellitic dianhydride, 3,3,4,4'-benzophenonetetracarboxylic dianhydride, 3,3,4,4'-diphenyltetracarboxylic dianhydride, 2,3,6,7-naphthalenetetracarboxylic dianhydride, 1,4,5,8-naphthalenetetracarboxylic dianhydride, 4,4'-sulfonyldiphthalic dianhydride, 2,2-bis(3,4-dicarboxyphenyl)propane dianhydride, bis(3,4-dicarboxyphenyl)ether dianhydride, 4,4'-[3,3'-(alkylphosphoryl diphenylene)-bis(iminocarbonyl)]diphthalic dianhydride, adduct of hydroquinone diacetate and trimellitic anhydride, and adduct of diacetyldiamine and trimellitic anhydride; alicyclic tetracarboxylic dianhydrides such as 5-(2,5-dioxo tetrahydrofuryl)-3-methyl-3-cyclohexene-1,2-dicarboxylic anhydride (Epichlone B-4400, manufactured by Dainippon Ink and Chemicals, Inc.), 1,2,3,4-cyclopentanetetracarboxylic dianhydride, 1,2,4,5-cyclohexanetetracarboxylic dianhydride, and tetrahydrofurantetracarboxylic dianhydride; and aliphatic tetracarboxylic dianhydrides such as 1,2,3,4-butanetetracarboxylic dianhydride, and 1,2,4,5-pentanetetracarboxylic dianhydride.

It is possible to prepare at least one diol compound having at least one carboxyl group(ii), by ring-opening of the tetracarboxylic dianhydride with a diol compound. However, it is also possible to prepare the polyurethane resin according to the invention, by first allowing a diol compound to react with the diisocyanate compound (i) and then allowing the reaction product to react with the tetracarboxylic dianhydride, and the method is also included in the scope of the invention. Examples of the methods of introducing the structural unit derived from a tetracarboxylic dianhydride and a diol compound into the polyurethane resin include the following methods:
a) method of ring-opening a tetracarboxylic dianhydride with a diol compound and allowing the compound obtained having alcohol terminals to react with a diisocyanate compound; and
b) method of allowing a diisocyanate compound in the presence of an excess amount of a diol compound and allowing the urethane compound obtained having alcohol terminals to react with a tetracarboxylic dianhydride.

Among the at least one diol compounds having at least one carboxyl group, the compounds represented by Formula (5) are more favorable, because they are superior in solubility in solvents and easier to synthesize. The at least one diol compound having at least one carboxyl group is introduced into the polyurethane resin binder in an amount that the polyurethane resin binder contains the carboxyl groups in the range of 0.2 to 4.0 meq/g, preferably 0.3 to 3.0 meq/g, more preferably 0.4 to 2.0 meq/g, particularly preferably 0.5 to 1.5 meq/g, and most preferably 0.6 to 1.2 meq/g. Thus, the content of the at least one diol compound having at least one carboxyl group derived from structure in the polyurethane resin binder is, for example, 5 to 45 mol %, preferably 10 to 40 mol %, and more preferably 15 to 35 mol %, although it is selected properly according to the number of carboxyl groups, the kind of the other diol component used, the acid value and the molecular weight of the polyurethane resin binder obtained, the composition and pH of the developing solution, and others.

### (iii) Diisocyanate compound containing a crosslinkable group

Examples of the crosslinkable group-containing diisocyanate compounds include the addition-reaction products of a triisocyanate compound and a monofunctional alcohol or amine compound having a crosslinkable group at the equimolar ratio.

Examples of the triisocyanate compounds include, but are not limited to, the followings.

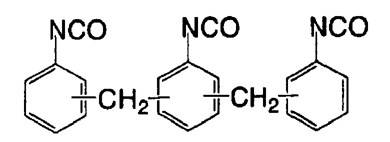

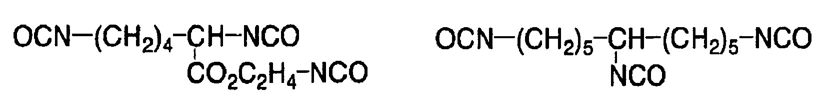

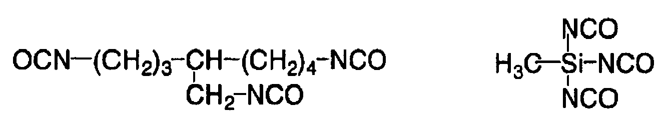

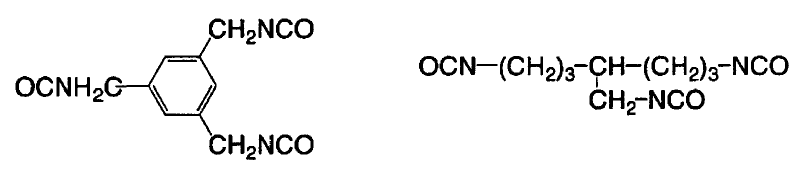

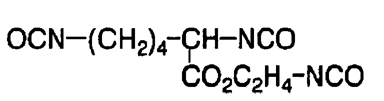

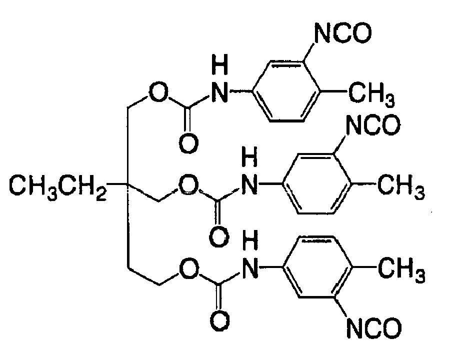

Examples of the monofunctional alcohol or amine compounds having a crosslinkable group include, but are not limited to, the followings: 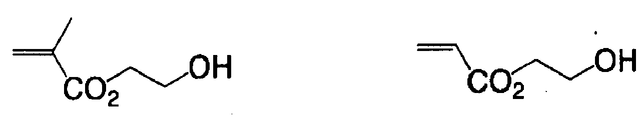 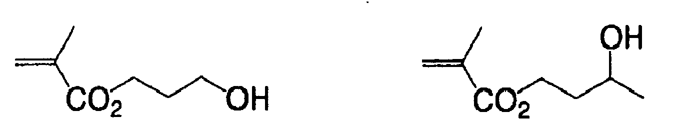 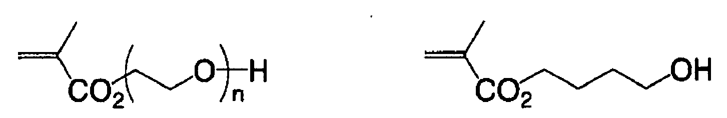 n is an integer of 2 to 10

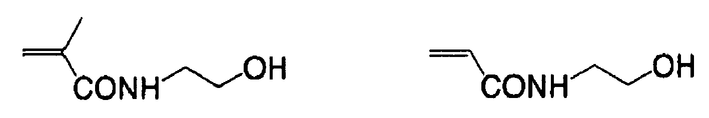

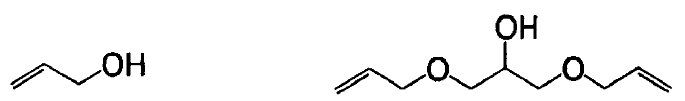

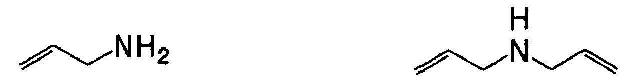

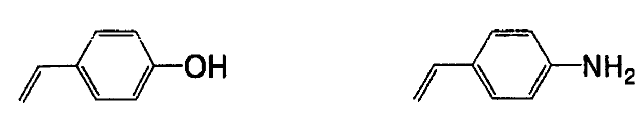

The crosslinkable group is preferably introduced onto the side chain of the polyurethane resin, by a method of using a diisocyanate compound having a crosslinkable group on the side chain as the raw material for production of the polyurethane resin. Examples of the diisocyanate compounds having a crosslinkable group on the side chain prepared in reaction of a triisocyanate compound and a monofunctional alcohol or amine compound having a crosslinkable group at the equimolar ratio include, but are not limited to, the followings:

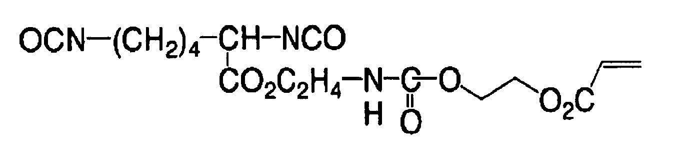

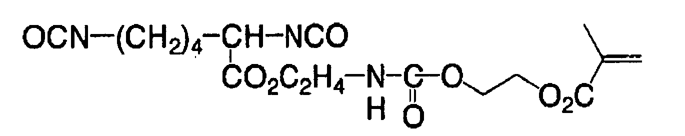

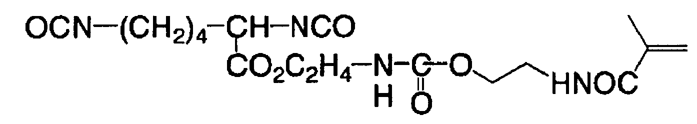

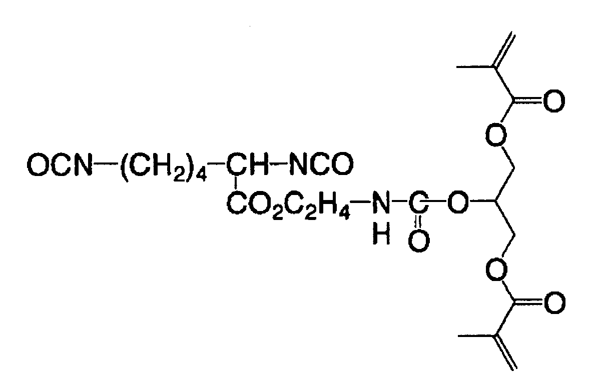

### (iv) Other diol compounds

In addition to the method above, the unsaturated group is also favorably introduced onto the side chain of the polyurethane resin by a method of using a diol compound having an unsaturated group on the side chain as the raw material for production of the polyurethane resin. Example of such diol compounds include commercially available products such as trimethylolpropane monoallylether, and also, compounds prepared in reaction of a halogenated diol, triol, or amino diol compound with a unsaturated group-containing carboxylic acid, acid chloride, isocyanate, alcohol, amine, thiol, or alkyl halide compound. Typical examples of the compounds include, but are not limited to, the followings.

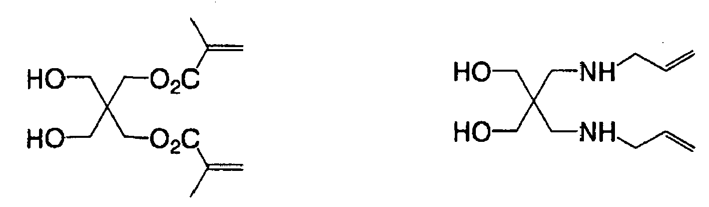

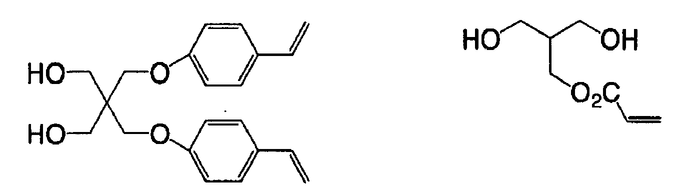

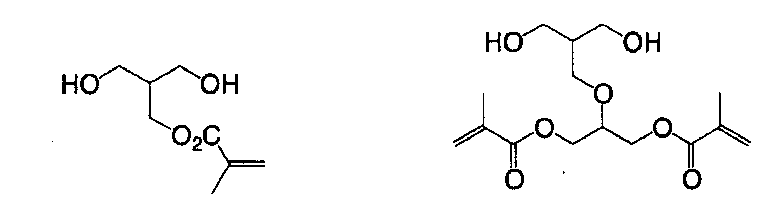

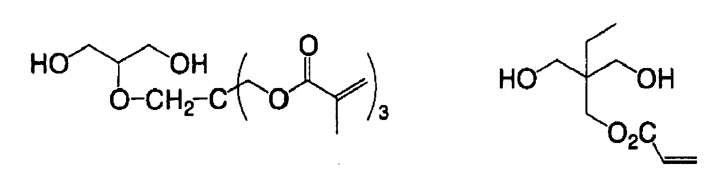

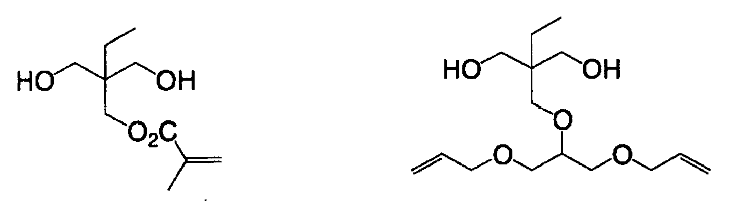

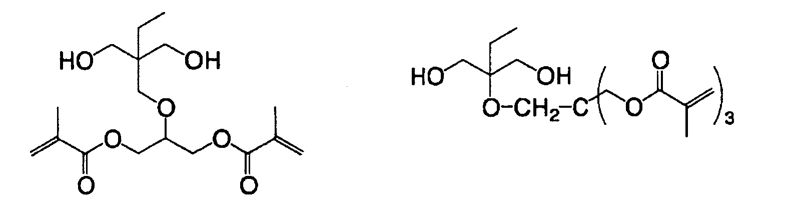

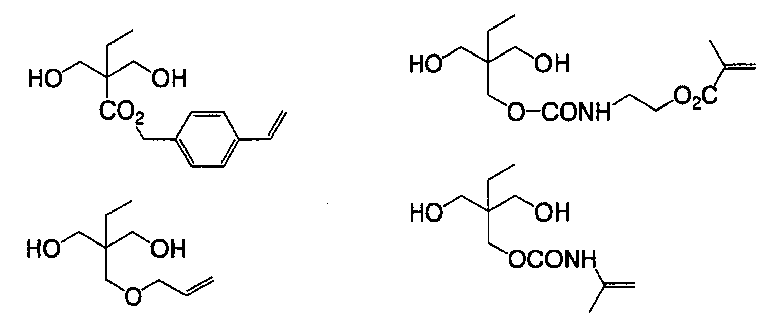

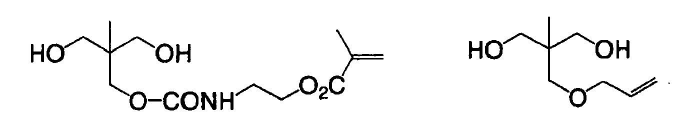

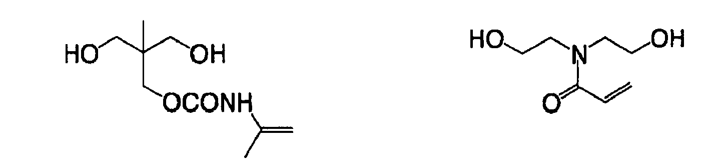

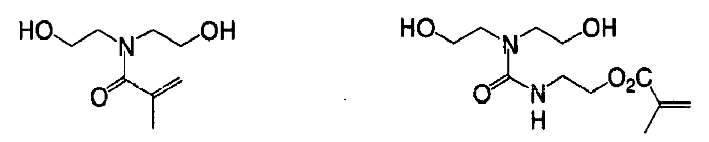

Yet other favorable diol compounds include the ethylene glycol compounds represented by the following Formula (A').

HO-(CH₂CH₂O)ₙ-H Formula (A')

(wherein, n is an integer of 1 or more).

Also included are random and block copolymers of terminal hydroxyl group-containing ethyleneoxide and propyleneoxide.

Other favorable examples thereof include bisphenol A-ethyleneoxide adducts (addition number of ethyleneoxide: 27 or more and 100 or less), bisphenol F-ethyleneoxide adducts (addition number of ethyleneoxide: 22 or more 100 or less), hydrogenated bisphenol A-ethyleneoxide adducts (addition number of ethyleneoxide: 23 or more 100 or less), and hydrogenated bisphenol F-ethyleneoxide adducts (addition number of ethyleneoxide: 18 or more 100 or less). More specifically, the ethylene glycol compounds represented by Formula (A') are preferable; ethylene glycol compounds having 2 to 50 as n are more preferably; ethylene glycol compounds having 3 to 30 as n are more preferably; and ethylene glycol compounds having 4 to 10 as n are particularly preferable, from the point of staining resistance.

The diol compounds represented by the following Formula (16), (17) or (18) are also used favorably.

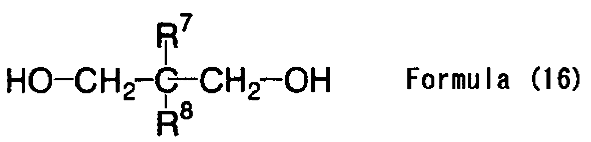

HO-CH₂-C≡C-CH₂-OH Formula (17)

HO-CH₂-CH=CH-CH₂-OH Formula (18)

In the Formula, R⁷ and R⁸ each independently represent an alkyl group that may be substituted, preferably an alkyl group having 1 to 10 carbon atoms that may be substituted with a cyano or nitro group, a halogen atom (-F, -Cl, -Br, or -I), -CONH₂, -COOR, or -OR (wherein, the groups R each independently represent an alkyl group having 1 to 10 carbon atoms or an aryl or aralkyl group having 7 to 15 carbon atoms).

Typical examples of the diol compounds represented by Formula (16) include the followings:

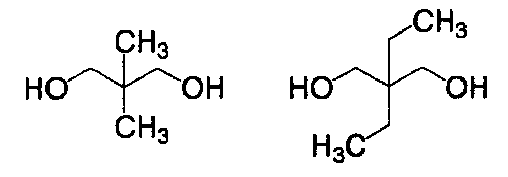

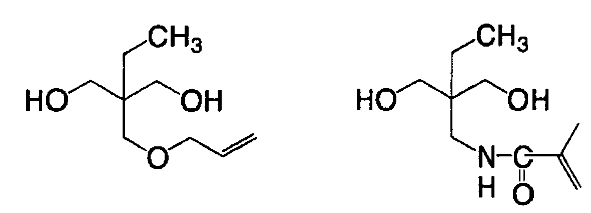

Examples of the compounds represented by Formula (17) include 2-buten-1,4-diol, and those by Formula (18) include cis-2-buten-1,4-diol, trans-2-buten-1,4-diol, and the like.

The diol compounds represented by the following Formulae (19) and (20) are also used favorably.

HO-L⁸-NH-CO-L⁹-CO-NH-L⁸-OH Formula (19)

HO-L⁹-CO-NH-L⁸-OH Formula (20)

In the Formulae, L⁸ and L⁹ each independently represent a bivalent aliphatic hydrocarbon group, an aromatic hydrocarbon group or a heterocyclic group that may have one or more substituent groups (such as alkyl, aralkyl, aryl, alkoxy, aryloxy, or halogen atom (-F, -Cl, -Br, or -I)). L⁸ or L⁹ may contain another functional group unreactive with the isocyanate group such as a carbonyl, ester, urethane, amido, or ureido group as needed. L⁸ and L⁹ may bind to each other, form a ring.

In addition, the diol compounds represented by the following Formulae (21) and (22) are used favorably.

HO-Ar²-(L¹⁶-Ar³)ₙ-OH Formula (21)

HO-Ar²-L¹⁶-OH Formula (22)

In the Formula, L¹⁶ represents a bivalent aliphatic hydrocarbon group that may have one or more substituent groups (such as alkyl, aralkyl, aryl, alkoxy, aryloxy, or halogeno).

L¹⁶ may have another functional group unreactive with the isocyanate group such as an ester, urethane, amido or ureido group as needed.

Ar² and Ar³ each independently represent a bivalent aromatic hydrocarbon group that may have one or more substituents, preferably an aromatic group having 6 to 15 carbon atoms. n is an integer of 0 to 10.

Typical examples of the diol compounds represented by Formula (21) or (22) include the followings: catechol, resorcin, hydroquinone, 4-methylcatechol, 4-t-butylcatechol, 4-acetylcatechol, 3-methoxycatechol, 4-phenylcatechol, 4-methylresorcin, 4-ethylresorcin, 4-t-butylresorcin, 4-hexylresorcin, 4-chlororesorcin, 4-benzylresorcin, 4-acetylresorcin, 4-carbomethoxyresorcin, 2-methylresorein, 5-methylresorcin, t-butylhydroquinone, 2,5-di-t-butylhydroquinone, 2,5-di-t-amylhydroquinone, tetramethylhydroquinone, tetrachlorohydroquinone, methylcarboaminohydroquinone, methylureidohydroquinone, methylthiohydroquinone, benzonorbomen-3,6-diol, bisphenol A, bisphenol S, 3,3'-dichlorobisphenol S, 4,4'-dihydroxybenzophenone, 4,4'-dihydroxybiphenyl, 4,4' -thiodiphenol, 2,2'-dihydroxydiphenylmethane, 3,4-bis(p-hydroxyphenyl)hexane, 1,4-bis(2-(p-hydroxyphenyl)propyl)benzene, bis(4-hydroxyphenyl)methylamine, 1,3-dihydroxynaphthalene, 1,4-dihydroxynaphthalene, 1,5-dihydroxynaphthalene, 2,6-dihydroxynaphthalene, 1,5-dihydroxyanthraquinone, 2-hydroxybenzyl alcohol, 4-hydroxybenzyl alcohol, 2-hydroxy-3,5-di-t-butylbenzyl alcohol, 4-hydroxy-3,5-di-t-butylbenzyl alcohol, 4-hydroxyphenethyl alcohol, 2-hydroxyethyl-4-hydroxybenzoate, 2-hydroxyethyl-4-hydroxyphenyl acetate, resorcin mono-2-hydroxyethylether, and the like.

In addition to the polyurethane resins obtained by introducing the crosslinkable group on the side chain during preparation of the polyurethanes polyurethane resins obtained by introducing a crosslinkable group into a carboxyl group-containing polyurethane by polymerization reaction such as those described in JP-A No. 2003-270775 may be used as the binder polymers according to the invention.

The molecular weight of the binder polymer according to the invention is decided properly, from the viewpoints of image-forming property and printing durability. The molecular weight is preferably in the range of 2,000 to 1,000,000, more preferably 5,000 to 500,000, and more preferably 10,000 to 200,000.

The binder polymers for use in the invention may be used alone or in combination of two or more. The binder polymer may be used also as a mixture with one or more other binder polymers having no crosslinkable group. Any one of known alkali-soluble or swelling binders may be used without restriction as the binder polymer used in combination, and typical favorable examples thereof include acrylic binders and urethane binders commonly used in the art.

The content of the binder polymer is 20 to 80 mass %, preferably 25 to 75 mass %, with respect to the total solid matters in the coating solution.

The addition-polymerizable compound and the binder polymer are preferably used at a weight ratio in the range of 1/9 to 7/3, more preferably in the range of 3/7 to 5/5.

### (Other components)

A dye or pigment may be added to the coating solution according to the invention, for coloration of the photosensitive layer.

Examples of the colorants include pigments such as phthalocyanine pigments, azo pigments, carbon black, and titanium oxide; and dyes such as ethyl violet, crystal violet, azo dyes, anthraquinone dyes, and cyanine dyes. The amount of the dye or pigment added is preferably, approximately 0.5 mass % to approximately 5 mass % in the entire composition.

An inorganic filler or other known additives such as plasticizer may also be added to the coating solution according to the invention, for improvement in the physical properties of the photosensitive layer of hardened film.

Examples of the plasticizers include dioctyl phthalate, didodecyl phthalate, triethylene glycol dicaprylate, dimethylglycol phthalate, tricresyl phosphate, dioctyl adipate, dibutyl sebacate, triacetyl glycerol, and the like; and when used together with a binder, the plasticizer may be added in an amount of 10 mass % or less with respect to the total weight of the ethylenic compound and the binder.

A higher fatty acid derivative such as behenic acid, behenic amide or the like may be added to the coating solution according to the invention, and be left on the surface of the photosensitive layer in the drying process after application, as needed for prevention of the polymerization inhibition by oxygen. The amount of the higher fatty acid derivative added is preferably, approximately 0.5 mass % to approximately 10 mass % in the entire composition.

In addition, a UV initiator, a thermal crosslinking agent, or the like for acceleration of the heating-exposure after development may be added to the coating solution according to the invention, for improvement in the film strength (printing durability) described below.

In addition, additives for improvement of the adhesion between the photosensitive layer and the supporting plate and the removability of the unexposed photosensitive layer during development may be added to the coating solution. Examples of the additives include compounds having a relatively stronger interaction with a supporting plate such as compounds having a diazonium structure and phosphonate compounds. Addition of a hydrophilic polymer such as polyacrylic acid or polysulfone acid also enables improvement in the developing efficiency and the staining resistance of non-image region.

### (Organic solvent)

The coating solution according to the invention contains an organic solvent for solubilization of the components described above.

Examples of the organic solvents for use therein include acetone, methylethylketone, cyclohexane, ethyl acetate, ethylene dichloride, tetrahydrofuran, toluene, ethylene glycol monomethylether, ethylene glycol monoethylether, ethylene glycol dimethylether, propylene glycol monomethylether, propylene glycol monoethylether, acetylacetone, cyclohexanone, diacetone alcohol, ethylene glycol monomethylether acetate, ethylene glycol ethylether acetate, ethylene glycol monoisopropylether, ethylene glycol monobutylether acetate, 3-methoxypropanol, methoxymethoxyethanol, diethylene glycol monomethylether, diethylene glycol monoethylether, diethylene glycol dimethylether, diethylene glycol diethylether, propylene glycol monomethylether acetate, propylene glycol monoethylether acetate, 3-methoxypropyl acetate, N,N-dimethylformamide, dimethylsulfoxide, γ-butylolactone, methyl lactate, ethyl lactate, and the like.

These organic solvents may be used alone or as a mixture.

The concentration of the solid matters in the coating solution is preferably 2 to 50 mass %.

### "Formation of photosensitive layer"

In the invention, a photosensitive layer is formed, as the coating solution containing the components above coated on a substrate. The amount of the photosensitive layer coated on supporting plate, which exerts influences mainly on the sensitivity and developing efficiency of photosensitive layer and the strength and printing durability of exposed film, is selected properly according to its application. An excessively smaller coating amount results in insufficient printing durability. Alternatively, an excessively larger coating amount is also unfavorable, because it results in deterioration in sensitivity and elongation of exposure and development.

The coating amount of the planographic printing plate obtained by the invention is preferably in the range of approximately 0.1 g/m² to approximately 10 g/m², more preferably 0.5 to 5 g/m², by mass after drying.

### "Supporting plate"

The supporting plate for use in the invention preferably has a hydrophilic surface on the face where the photosensitive layer described is formed. Any one of known hydrophilic supporting plates for use in planographic printing plates may be used without restriction as the hydrophilic supporting plate. The supporting plate for use is preferably a dimensionally stable plate-shaped material, and favorable examples thereof include paper, papers laminated with a plastic film (such as of polyethylene, polypropylene and polystyrene), metal plates (such as of aluminum, zinc, and copper), plastic films (such as of cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, and polyvinylacetal), plastic films laminated or deposited with the metal described above, and the like; and the surface of these supporting plate may be treated chemically or physically as needed, properly for example for improvement in hydrophilicity and strength.

Particularly favorable examples of the supporting plates include paper, polyester films and aluminum plates; and among them, aluminum plates, which are superior in dimensional stability and cheaper that gives a surface superior in hydrophilicity and strength by surface treatment as needed, are particularly preferable. The composite sheet of a polyethylene terephthalate film and an aluminum sheet described in JP-B No. 48-18327 is also preferable.

Favorable aluminum plates are pure aluminum plates and alloy plates containing aluminum as the main component and small amounts of foreign elements and plastic films laminated or deposited with aluminum. The foreign elements contained in the aluminum alloys include silicon, iron, manganese, copper, magnesium, chromium, zinc, bismuth, nickel, and titanium. The content of the foreign elements in the alloy is 10 mass % at the maximum. Although the most favorable aluminum in the invention is pure aluminum, the aluminum plate may contain a small amount of foreign elements, as it is difficult to prepare completely pure aluminum due to the problems in refining process. As described above, the aluminum plates to be used in the invention are not particularly specified in composition, and any one of the aluminum plates known and used in the art may be used.

The thickness of the aluminum plate for use in the invention is about 0.1 mm to 0.6 mm, preferably 0.15 mm to 0.4 mm, and particularly preferably 0.2 mm to 0.3 mm.

When a metal supporting plate, especially having an aluminum surface, is used, it is preferably surface-treated, for example, by a surface-roughening (sand blasting) treatment, an immersion treatment in a solution containing sodium silicate, potassium fluorozirconate, or a phosphate salt, or an anodizing treatment.

Various methods may be used for surface roughening of the aluminum plate, and examples thereof include methods of scratching mechanically, dissolving the surface electrochemically, and dissolving selectively the surface chemically. The mechanical methods include methods known in the art such as ball grindling, brush grinding, blast grinding, and buff grinding. The electrochemical surface roughening may be conducted, for example, in an electrolyte containing hydrochloric acid or nitric acid by applying alternate or direct current. Alternatively, the combined mechanical and electrochemical method described in JP-A No. 54-63902 may also be used. If desired, the surface of the aluminum plate is subjected, before surface roughening, to degreasing treatment for removing the rolling oils on the surface thereof, with a surfactant, organic solvent, aqueous alkaline solution, or the like.

An aluminum plate immersed in an aqueous sodium silicate solution after surface roughening is also used favorably. The aluminum plate described in JP-B No. 47-5125, which is previously immersed in an aqueous solution of an alkali metal silicate salt after anodizing treatment, is also used favorably. The anodizing treatment is performed, for example, by applying electric current to the aluminum plate as the anode in an electrolyte solution of one or more aqueous solutions containing an inorganic acid such as phosphoric acid, chromic acid, sulfuric acid or boric acid, or an organic acid such as oxalic acid or sulfamic acid, or the salt thereof. Alternatively, the silicate electrodeposition described in U.S. Patent No. 3658662 is also effective.

Further, combination of the electrolytic graining disclosed in JP-B No. 46-27481 and JP-A Nos. 52-58602 and 52-30503 and the anodizing and sodium silicate treatments is also useful as the surface treatment. The substrate disclosed in JP-A No. 56-28893, which is treated by mechanical surface roughening, chemical etching, electrolytic graining, anodizing treatment, and sodium silicate treatment in that order, is also favorable.

In addition, a substrate undercoated with a water-soluble resin such as a polyvinylphosphonic acid, polymer or copolymer having a sulfonic acid group on the side chain, polyacrylic acid, a water-soluble metal salt (such as zinc borate) or with a yellow dye, an amine salt, or the like after these treatments is also favorable.

Further, the sol-gel-treated substrate disclosed in JP-A No. 7-159983, to which a functional group radically causing addition reaction is bound covalently, is also used favorably.

Another preferable example is a substrate having a water-resistant hydrophilic layer on the surface of a substrate. Examples of the surface layers include the layer consisting of an inorganic pigment and a binder described in U.S.P. No. 3055295 and JP-A No. 56-13168, the hydrophilic swelling layer described in JP-A No. 9-80744, the sol-gel film containing titanium oxide, polyvinyl alcohol, silicic acid, and others described in Japanese Patent Application National Publication (Laid-Open) No. 8-507727, and the like.

The hydrophilizing treatment is performed not only for hydrophilizing the surface of the supporting plate but also, for example, for prevention of the undesirable reactions of the photosensitive layer formed thereon and improvement in the adhesiveness of the photosensitive layer.

A back coat is formed as needed on the rear face of the supporting plate.

The coating layer of an organic polymer compound described in JP-A No. 5-45885 and a metal oxide obtained by hydrolyzing and polycondensing the organic or inorganic metal compound described in JP-A No. 6-35174 is used favorably as the back coat.

Among these coating layers, coating layers of a metal oxide obtained from a silicon alkoxide compound such as Si(OCH₃)₄, Si(OC₂H₅)₄, Si(OC₃H₇)₄, or Si(OC₄H₉)₄, which is cheaper and available, is particularly preferable, because they are superior in development endurance.

### "Protective layer"

In the scanning-exposure planographic printing plate, a favorable embodiment of the invention, a protective layer is preferably formed additionally on the photosensitive layer, because the exposure is normally done in air. The protective layer prevents penetration into the photosensitive layer of oxygen and low-molecular weight compounds including basic substances present in air that inhibit the image-forming reaction occurring in the photosensitive layer by light exposure and thus, allows exposure in air. Thus, the protective layer is preferably lower in the permeability of low-molecular weight compounds such as oxygen, practically non-inhibitive to transmission of the light for exposure, superior in adhesiveness to the photosensitive layer, and easily removable in the developing process after exposure. Various inventions concerning the protective layer were made, and some of them are described in detail in U.S. Patent No. 3458311 and JP-ANo. 55-49729.

Materials for use in the protective layer are preferably water-soluble polymer compounds relatively higher in crystallinity, and typical examples thereof include water-soluble polymers such as polyvinylalcohol, polyvinylpyrrolidone, acidic celluloses, gelatin, gum arabic, and polyacrylic acid; and among them, polymers having polyvinylalcohol as the primary component are most effective in improving the basic properties of the protective layer such as oxygen-blocking property and removability during development. The polyvinyl alcohol for use in protective layer may be partly substituted in the form of ester, ether or acetal, if it still has some unsubstituted vinyl alcohol units necessary for desirable oxygen-blocking property and water-solubility. In addition, the polyvinyl alcohol may contain some other copolymerization components.

Typical examples of the polyvinyl alcohols are those having a molecular weight in the range of 300 to 2,400 that are hydrolyzed at an amount of 71 to 100%. More specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, and L-8, manufactured by Kuraray Co. Ltd. and the like.

The components of the protective layer (kind of PVA, use of other additives) and the amounts thereof are determined according to the desirable oxygen-blocking property, removability during development, background soil, adhesiveness, and scratch resistance of the protective layer. Generally, the oxygen-blocking property and thus the sensitivity become greater and the film thickness becomes larger, as the hydrolysis ratio of the PVA used becomes higher (as the content of unsubstituted vinyl alcohol units in the protective layer becomes higher). However, excessive increase in oxygen-blocking property may lead to the problems of undesirable polymerization reaction during production and storage, undesirable background soil, and blurring of image lines during image exposure. In addition, the adhesiveness to the image region and the scratch resistance of the protecting layer are also very important in handling the plates. When a hydrophilic layer of water-soluble polymer is formed over an oleophilic photosensitive layer, the hydrophilic layer is often separated due to insufficient adhesive power, and the photosensitive layer in the separated region causes defects such as improper hardening of the layer due to the polymerization inhibition by oxygen. Various methods are proposed for improving the adhesiveness between the two layers. For example, it was disclosed in U.S. Patent Nos. 292,501 and 44,563 that a hydrophilic layer having a sufficiently large adhesiveness can be prepared by mixing an acrylic emulsion or a water-insoluble vinylpyrrolidone-vinyl acetate copolymer with a hydrophilic polymer mainly containing polyvinyl alcohol in an amount of 20 to 60% by mass and coating the resulting composition onto a photosensitive layer. Any one of these known methods may be used for forming the protective layer according to the invention. Methods of forming the protective layer are described in detail, for example, in U.S. Patent No. 3,458,311 and JP-A No. 55-49729.

The protective layer may have another function additionally. For example, it is possible to increase safelight endurance further without deterioration in sensitivity, by adding a colorant (for example, a water-soluble dye) that is superior in transmission of the irradiating light at a wavelength of 350 to 450 nm but absorbs practically all light at a wavelength of 500 nm or more.

### "Undercoat layer (intermediate layer)"

An undercoat layer may be formed between the photosensitive layer and the supporting plate on the planographic printing plate obtained by the invention, for improvement in the adhesion between the photosensitive layer and the supporting plate and for increase the removability of the unexposed photosensitive layer.

A compound interacting with the supporting plate is used for the undercoat layer, and typical examples thereof include compounds having a diazonium structure, phosphone compounds, and the like. Use of a hydrophilic polymer such as polyacrylic acid or polysulfone acid as the undercoat layer is also preferable for improvement in the removability of non-image region.

### "Plate-making"

The planographic printing plate obtained by the method of producing a planographic printing plate according to the invention is engraved in the following manner.

The planographic printing plate obtained as described above shows favorable characteristics to engraving especially by scanning exposure.

General methods of scanning exposure are described, for example, in Yoshihiro Takekida Ed., "Photoprinter Design", published by Triceps (1985). For example, an image is formed on a plate precursor by main-scanning in a direction and sub-scanning in the direction perpendicular thereto (laser scanning) on the entire plate by using a collimated beam (diameter: normally several to several dozens of micrometers) as the light source, while controlling on/off of the irradiation according to the image information.

It is necessary to use a beam smaller in diameter for irradiation of a higher-definition image, and, in such a case, to accelerate the scanning speed and/or to increase the number of the beams, in order to draw an image on the entire area of the plate in a shorter period of time. The period of exposure at each point on the plate precursor is normally a short period of microseconds in the scanning exposure, for obtaining an exposure period practically sufficient. Thus, it is necessary to use a high-power light source emitting light continuously as the light source, to give an exposure energy sufficient to the photosensitive plate precursor in a short period of time.

Various lasers (such as Ar, FD-YAG, He-Ne, LD, and YAG) emitting light continuously in the visible to infrared light region are now available as such light sources, and among them, visible light sources that emit light such as Ar ion laser (488 nm) and FD-YAG laser (532 nm) having an output of about dozens to hundreds mW are used favorably, because they are superior in photosensitivity, cost and availability.

The kind and the wavelength of the light source for the planographic printing plate obtained in the invention is selected properly according to the kind of the photosensitive composition constituting the photosensitive layer; and thus, it is possible to perform scanning exposure, even with a light source at a short wavelength (blue and/or ultraviolet laser), light source at a longer wave length (red, infrared laser), or other light source. Short-wavelength (blue and/or ultraviolet) semiconductor lasers using a GaN-based material are intensively studied particularly recently, and the planographic printing plate according to the invention can also be applied favorably to the scanning exposure using the same.

The unexposed region of the photosensitive layer on the planographic printing plate obtained by the invention is removed with a developing solution after image exposure, for obtaining an image.

Favorable developing solutions include the developing solution described in JP-B No. 57-7427, and typical examples thereof include aqueous solution containing an inorganic base such as sodium silicate, potassium silicate, sodium hydroxide, potassium hydroxide, lithium hydroxide, trisodium phosphate, disodium phosphate, triammonium phosphate, diammonium phosphate, sodium metasilicate, sodium bicarbonate, or ammonia water, or an organic base such as monoethanolamine or diethanolamine. Such a base is added at a solution concentration of 0.1 to 10 mass %, preferably 0.5 to 5 mass %.

The aqueous alkaline solution may contain as needed a surfactant and an organic solvent such as benzyl alcohol, 2-phenoxyethanol or 2-butoxyethanol in a small amount. Examples thereof include those described in U.S. Patent Nos. 3375171 and 3615480, and also, the developing solutions described in JP-A Nos. 50-26601 and 58-54341 and JP-B Nos. 56-39464 and 56-42860.

The planographic printing plate developed as described above is preferably post-treated with washing water, a rinse solution containing a surfactant, and a desensitizing solution containing gum arabic and a starch derivative.

In another plate-making process, the entire surface of the printing plate may be as needed heated before or during exposure, or in the period from exposure to development. The heating accelerates the image-forming reaction in the photosensitive layer, possibly giving advantages such as improvement in sensitivity and printing durability and stabilization in sensitivity. It is also effective to post-heat or irradiate the entire surface of the image after development for improvement in image intensity and printing durability. The heating before development is preferably performed normally under a mild condition at 150°C or lower.

An excessively higher temperature results in problems such as fogging of non-image regions. The heating after development is performed under a very severe condition, normally in a temperature range of 200 to 500°C. An excessively lower temperature leads to insufficient improvement in image intensity, while an excessively higher temperature to problems such as deterioration of the supporting plate and thermal decomposition of the image region.

The planographic printing plate obtained after these treatments is used for printing of multiple papers, for example, in an offset printing machine.

### EXAMPLES

Hereinafter, the present invention will be described in detail with reference to Examples, but it should be understood that the invention is not restricted thereby.

### [Example 1]

### (Preparation of supporting plate)

An web-shaped IS aluminum plate having a thickness of 0.30 mm was etched as it is immersed in 10% sodium hydroxide solution at 70°C for 60 seconds, washed with running water, neutralized, and washed with 20% HNO₃ solution, and the, washed with water. The aluminum plate was surface-roughened electrolytically in aqueous 1% nitric acid solution at an anodic current of 300 coulomb/dm² under the condition of a VA of 12.7 V by using an alternate sine-waveform electric current. The surface roughness of the resulting aluminum plate determined was 0.45 µm (as Ra). The aluminum plate was then immersed in aqueous 30% H₂ SO₄ solution and desmutted at 55°C for 2 minutes; after forming a cathode on the surface-roughened face, the aluminum plate was anodized in aqueous 20% H₂ SO₄ at 33°C, at an electric current density of 5 A/dm² for 50 seconds, giving an anodized film having a thickness of 2.7 g/m².

A back coat layer-coating solution was coated on the rear face the substrate thus treated by using the following sol-gel reaction solution, and the aluminum plate was heated and dried to a temperature of 60°C, giving a supporting plate having a back coat layer of the coating solution in an amount of 50 mg/m².

### <Sol-gel reaction solution>

- Tetraethyl silicate 50 parts by mass
- Water 20 parts by mass
- Methanol 15 parts by mass
- Phosphoric acid 0.05 parts by mass

The components above were mixed and stirred, until the mixture generated heat in approximately 5 minutes. The liquid shown below was added after reaction for 60 minutes, to give a back coat-coating solution.
- Pyrogallol formaldehyde condensate resin 4 parts by mass (molecular weight (Mw): 2,000)
- Dimethyl phthalate 5 parts by mass
- Methanol 1,000 parts by mass

### (Formation of undercoat layer)

An undercoat layer was formed on the aluminum plate having a back coat layer thus processed in the following manner.

First, the following liquid undercoat composition was prepared and stirred at 30°C. The composition generated heat in approximately 5 minutes and was allowed to react for 60 minutes reaction; the mixture was then transferred into another container; and 10,000 parts by mass of methanol was added thereto, to give an undercoat layer-coating solution.

Then, the undercoat layer-coating solution obtained was coated on the aluminum plate in an amount of 0.1 g/m², heated and dried to an aluminum-plate temperature of 70°C, and then, cooled to an aluminum-plate temperature of 50°C or lower, to form an undercoat layer.

### <Liquid undercoat composition>

- Compound having the following structure 96 parts by mass
- Methanol 100 parts by mass
- Water 14 parts by mass
- Phosphoric acid (aqueous 85% solution) 11 parts by mass
- Tetraethoxysilane 36 parts by mass
- 3-Methacryloxypropyltrimethoxysilane 50 parts by mass

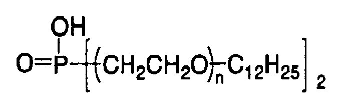

### (Formation of photosensitive layer)

A photosensitive layer-coating solution having the following composition was coated on the undercoat layer thus obtained to an coating amount of 1.4 g/m² after drying, heated and dried to an aluminum-plate temperature of 100°C, and then cooled to an aluminum-plate temperature of 50°C, to form a photosensitive layer.

The photosensitive layer-coating solution in Example 1 was kept at 26°C for 24 hours after preparation before application.

### <Photosensitive layer-coating solution>

- Addition-polymerizable compound (following compound A1) 2.0 parts by mass
- Binder polymer (following compound B1) 2.0 parts by mass
- Sensitization colorant (following compound C1) 0.2 parts by mass
- Polymerization initiator (following compound D1) 0.2 parts by mass
- Coinitiator (following compound E1) 0.3 parts by mass
- Dispersion of ε-phthalocyanine (following compound F1) 0.2 parts by mass
- Polymerization inhibitor 0.01 part by mass (N-nitrosophenylhydroxylamine aluminum salt)
- Nonionic fluorine-based surfactant 0.03 part by mass (Magafac F-176, manufactured by Dainippon Ink and Chemicals, Inc.)
- Methylethylketone 10.0 parts by mass
- Propylene glycol monomethylether acetate 10.0 parts by mass

Structures of the respective components in the photosensitive layer-coating solution are shown below.

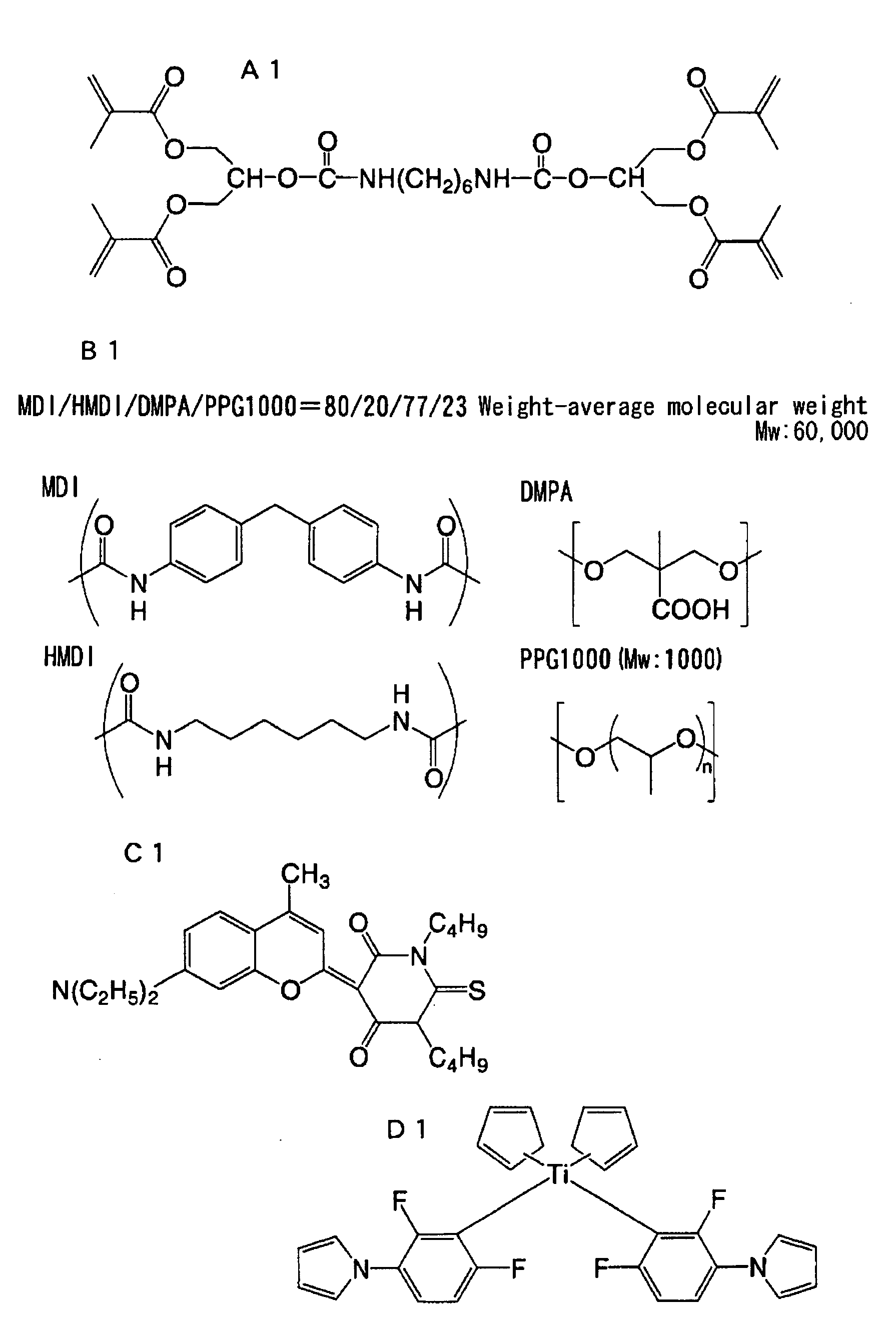

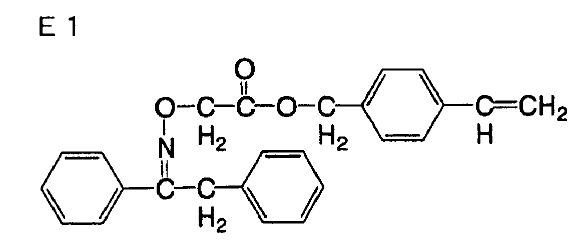

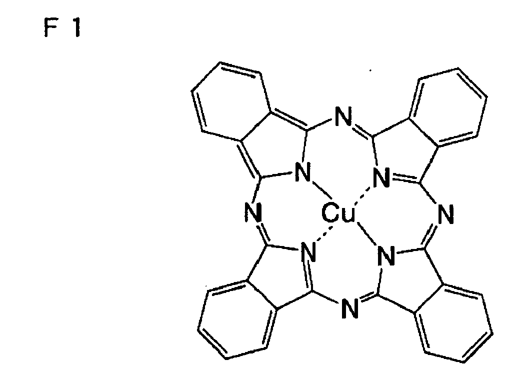

### (Formation of protective layer)

A protective layer-coating solution having the following composition was coated on the photosensitive layer obtained in a coating amount of 2.2 g/m² after drying, dried to a polyvinyl alcohol crystallinity of 0.45, and then, cooled to an aluminum-plate temperature of 50°C or lower.

### <Protective layer-coating solution>

- Polyvinylalcohol 20 parts by mass
   (PVA-105, manufactured by Kuraray Co., Ltd., saponification value: 98 mol %, polymerization degree: 500)
- Polyvinylpyrrolidone 2 parts by mass (K30, manufactured by Wako Pure Chemical Industries)
- Nonionic surfactant 0.5 parts by mass (EMAREXNP-10, manufactured by Nihon-Emulsion Co., Ltd.)
- Distilled water 360 parts by mass

Then, the protective layer was conditioned to a water content of 4.0% and wound as a web roll. The web roll was cut together with an insert paper described below into sheet-shaped material, giving photosensitive planographic printing plates.

### (Insert paper)

Bleached Kraft pulp was beaten, and the pulp slurry was diluted to a concentration of 4%. A synthetic sizing agent was added to the stock in an amount of 0.4 mass %, and aluminum sulfate to a pH of 5.0. A paper strength additive mainly containing starch was added to the stock in an amount of 3.0 mass %, and the stock was sheeted into an insert paper having a density 0.75 g/m², a smoothness of 25 seconds, a water content of 6.0 mass %, and a basis weight of 38 g/m².

### [Example 2]

A photo-polymerizable planographic printing plate was prepared in a similar manner to Example 1, except that the photosensitive layer-coating solution prepared in Example 1 was coated after storage at a temperature of 23°C for 15 hours.

### [Example 3]

A photo-polymerizable planographic printing plate was prepared in a similar manner to Example 1, except that the photosensitive layer-coating solution prepared in Example 1 was coated after storage at a temperature of 23°C for 180 hours.

### [Example 4]

A photo-polymerizable planographic printing plate was prepared in a similar manner to Example 1, except that the photosensitive layer-coating solution prepared in Example 1 was coated after storage at a temperature of 28°C for 15 hours.

### [Example 5]

A photo-polymerizable planographic printing plate was prepared in a similar manner to Example 1, except that the photosensitive layer-coating solution prepared in Example 1 was coated after storage at a temperature of 28°C for 180 hours.

### [Comparative Example 1]

A photo-polymerizable planographic printing plate was prepared in a similar manner to Example 1, except that the photosensitive layer-coating solution prepared in Example 1 was coated after storage at a temperature of 20°C for 48 hours.

### [Comparative Example 2]

A photo-polymerizable planographic printing plate was prepared in a similar manner to Example 1, except that the photosensitive layer-coating solution prepared in Example 1 was coated after storage at a temperature of 20°C for 300 hours.

### [Comparative Example 3]

A photo-polymerizable planographic printing plate was prepared in a similar manner to Example 1, except that the photosensitive layer-coating solution prepared in Example 1 was coated after storage at a temperature of 30°C for 4 hours.

### [Comparative Example 4]

A photo-polymerizable planographic printing plate was prepared in a similar manner to Example 1, except that the photosensitive layer-coating solution prepared in Example 1 was coated after storage at a temperature of 30°C for 100 hours.

### [Evaluation]

Each of the planographic printing plates obtained was image-exposed in Luxel Plate Setter P-9600 CTP NEWS (manufactured by Fuji Photo Film Co., Ltd.) carrying an FD-YAG laser (532 nm) emitting a laser beam at an exposure intensity of 200 µJ/cm², under the conditions of 909 dpi and 100 lines/inch.

The printing plate was post-heated, washed with water, and developed normally by using a developing solution, DV-2 dilution solution (manufactured by Fuji Photo Film Co., Ltd., DV-2/water: 1/4], and a finishing gum solution FP-2W (manufactured by Fuji Photo Film Co., FP-2W/water: 1/1), after exposure in an automatic developing machine FLP125NFS manufactured by Fuji Photo Film Co., Ltd. The temperature of the developing solution was 25°C, and the period of immersion in the developing solution was approximately 22 seconds.

### (Evaluation of sensitivity)

The sensitivity was determined by measuring the 50% halftone dot area by using a Macbeth densitometer RD920. A result close to 50% indicates that the sensitivity is better and the reproducibility of the halftone dot is favorable. Results are summarized in the following Table 1.

### (Evaluation of developing efficiency)

The developing efficiency of the non-image region on each of the planographic printing plates obtained by exposure and development above was observed. The developing efficiency is an efficiency of removal of the photosensitive layer in unexposed region. "G1" indicates that no coloring of the unexposed region due to the residual photosensitive layer was present by visual observation. "G2" indicates that coloring of the unexposed region due to residual photosensitive layer was present by visual observation. Results are summarized in the following Table 1.

### (Evaluation of printing durability)

Each of the planographic printing plates obtained by exposure and development above was used for printing in Lithrone printing machine manufactured by Komori Corp., by using black ink DIC-GEOS (N) manufactured by Dainippon Ink and Chemicals, Inc. and an etching solution manufactured by Fuji Photo Film Co. Ltd. (EU-3/water/isopropyl alcohol: 1/89/10 (by volume)); and the printing durability thereof was determined by the number of printed papers when the density of the painted image became thinner by visual observation. Results are summarized in the following Table 1.

**Table 1**

| | Sensitivity (%) | Developing efficiency | Printing durability (×10,000 papers) |
|---|---|---|---|
| Example 1 | 50 | G1 | 20 |
| Example 2 | 50 | G1 | 20 |
| Example 3 | 50 | G1 | 20 |
| Example 4 | 50 | G1 | 20 |
| Example 5 | 50 | G1 | 20 |
| Comparative Example 1 | 60 | G2 | 25 |
| Comparative Example 2 | 45 | G1 | 15 |
| Comparative Example 3 | 55 | G2 | 23 |
| Comparative Example 4 | 40 | G1 | 10 |

The results in Table 1 demonstrated that the planographic printing plates prepared by the method of producing a planographic printing plate according to the invention in Examples 1 to 5 were superior all in sensitivity, developing efficiency, and printing durability.

## Claims

1. A method of producing a photosensitive planographic printing plate, comprising, forming a photosensitive layer by applying a coating solution containing a compound having an addition-polymerizable ethylenic double bond, a polymerization initiator, and a polymerization inhibitor on a substrate, wherein the coating solution is stored at a temperature of 23 to 28°C for 15 to 180 hours after preparation thereof and before application.

2. The method of producing a photosensitive planographic printing plate of Claim 1, wherein the storage period is 18 to 168 hours.

3. The method of producing a photosensitive planographic printing plate of Claim 1, wherein the compound having an addition-polymerizable ethylenic double bond is a compound having two or more terminal ethylenic unsaturated bonds.

4. The method of producing a photosensitive planographic printing plate of Claim 1, wherein the polymerization inhibitor is a compound selected from hexaarylbiimidazole compounds, carbon-halogen bond-containing compounds, onium salts, and metallocene compounds.

5. The method of producing a photosensitive planographic printing plate of Claim 1, wherein the coating solution further contains a binder polymer.

6. The method of producing a photosensitive planographic printing plate of Claim 5, wherein the binder polymer is an organic polymer compound soluble in, or swells in, aqueous alkaline solutions.

7. The method of producing a photosensitive planographic printing plate of Claim 5, wherein the binder polymer is an organic polymer compound soluble in water.

8. The method of producing a photosensitive planographic printing plate of Claim 5, wherein the binder polymer is a polyurethane resin having a crosslinking group on a side chain.

9. The method of producing a photosensitive planographic printing plate of Claim 1, wherein the coating solution further contains a sensitization colorant.

10. The method of producing a photosensitive planographic printing plate of Claim 9, wherein the sensitization colorant is a compound selected from the compounds represented by the following Formulae (I), (II), (III), (IV), and (V): 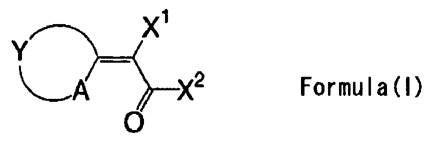 wherein in Formula (I) : A represents a S atom or NR⁶; R⁶ represents a monovalent non-metal atom group; Y represents a non-metal atom group forming a basic ring of a dye together with neighboring A and neighboring carbon atoms; X¹ and X² each independently represent a monovalent non-metal atom group; and X¹ and X² may bond together to form an acidic ring of the dye; 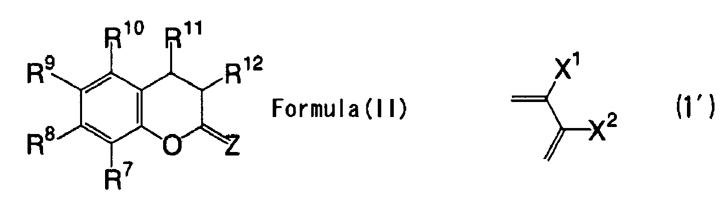 wherein in Formula (II) : =Z represents a carbonyl group, a thiocarbonyl group; an imino group, or an alkylidene group represented by partial structural Formula (1') above; X¹ and X² are the same as those in Formula (I); and R⁷ to R¹² each independently represent a monovalent non-metal atom group; 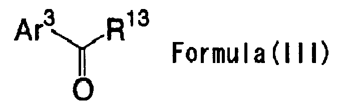 wherein in Formula (III) : Ar³ represents a substituted or unsubstituted aromatic or heteroaromatic group; R¹³ represents a monovalent non-metal atom group; and Ar³ and R¹³ may bond together to form a ring; 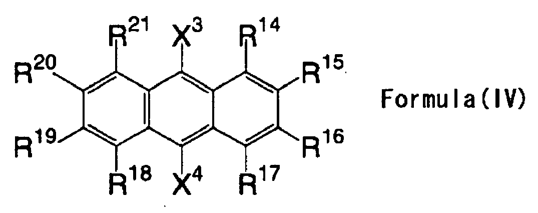 wherein in Formula (IV) : X³, X⁴, and R¹⁴ to R²¹ each independently represent a monovalent non-metal atom group; and 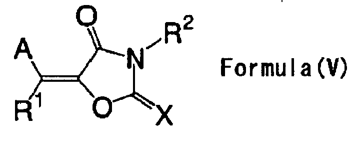 wherein in Formula (V) : A represents a substituted or unsubstituted aromatic ring or hetero ring; and X represents an oxygen or sulfur atom or N-(R³); R¹, R² and R³ each independently represent a hydrogen atom or a monovalent non-metal atom group; and A and R¹, or R² and R³, may bond together to form an aliphatic or aromatic ring.
